(19) Europäisches Patentamt
European Patent Office
Office européen des brevets

(11) Publication number: 0 247 141 B1

(12) EUROPEAN PATENT SPECIFICATION

(45) Date of publication of patent specification :
05.06.91 Bulletin 91/23

(51) Int. Cl.⁵ : **G01R 31/28**

(21) Application number : 86907057.3

(22) Date of filing : 22.10.86

(86) International application number :
PCT/US86/02277

(87) International publication number :
WO 87/02784 07.05.87 Gazette 87/10

(54) SYSTEM FOR TESTING AND REPAIRING PRINTED CIRCUIT BOARDS.

(30) Priority : 28.10.85 US 791874

(43) Date of publication of application :
02.12.87 Bulletin 87/49

(45) Publication of the grant of the patent :
05.06.91 Bulletin 91/23

(84) Designated Contracting States :
BE DE FR GB IT LU NL

(56) References cited :
EP-A- 0 050 014
WO-A-80/02599
DE-A- 3 040 340
GB-A- 2 136 140
US-A- 4 348 276

(73) Proprietor : CIMM, INC.
200 Jordan Road Suite 100
Troy, NY 12180 (US)

(72) Inventor : MATRONE, John, L.
233 Greenwood Drive
Schenectady, NY 12303 (US)
Inventor : STAMP, Ronald, L.
3 Gage Avenue
Albany, NY 12203 (US)
Inventor : BABCOCK, Douglas, M.
20 West Glenwood Drive
Latham, NY 12110 (US)

(74) Representative : Schüler, Horst, Dr.
Kaiserstrasse 69
W-6000 Frankfurt/Main 1 (DE)

## Description

This invention in general relates to a method and apparatus for testing and/or repairing printed circuit boards (PCBs), and in particular it relates to an automated multi-station system capable of testing and/or repairing PCBs of different types, concurrently, including : an input station for entering PCBs into said system ; a plurality of test and/or repair stations ; a transport system interconnecting all of said stations for transporting PCBs between said stations ; and control means for supervising transport of said PCBs by said transport system, operation of said input station and activation of said test and/or repair stations. The invention also relates to a method for automating test and/or repair operations to be performed on PCBs in a multi-station system so that such operations can be preformed by the system on PCBs of different types concurrently, wherein PCBs are transported between stations of the system by an interconnecting transport system under the control of a control unit.

The term printed circuit board as used herein refers generically to electrical circuits which are constructed on or within supporting strata. The use of this term is not intended to limit this invention to electrical circuits having conductive members formed by "printing" techniques nor to circuits formed on or within a supporting stratum of any specific construction.

In order to test such printed circuit boards (PCBs) it is necessary to establish electrical connection between the test system and selected nodes within the electrical circuits of the PCB. Conventionally this electrical connection is accomplished with a fixture assembly upon which the PCB is positioned. The fixture assembly incorporates a plurality of conductive probes (traditionally referred to as a bed of nails) which are selectively positioned therein to correspond to predetermined electrical nodes on the PCB. After the PCB is positioned upon the fixture assembly the probes are biased into electrical contact with such nodes. The various probes of the fixture assembly are in turn electrically connected to stimulus and measurement means within the test system which stimulate the nodes and which measure the responses which occur at the nodes of the PCB under test as a result of such stimulus. A separate fixture assembly is generally required for each different PCB to be tested due to the variation of the circuits of the PCB and of the electrical nodes located therein. Since the electrical connection between the electrical nodes of the PCB and the test system is very critical, since the trend is to design PCBs with electrical nodes which are very densely packed, and since there is such a variation in the size and configuration of the different PCBs, the accurate loading or positioning of a PCB with respect to the fixture assembly and the accurate loading and positioning of the fixture assembly as well as the electrical connection of the fixture assembly to the stimulus and measurement means of the test system have typically been manual processes which make up an excessively large proportion of the total test time. Attempts to automate such processes through the use of robotic arms or universal fixtures have been limited due to the required accuracy, the inherent variability in the size, shape, complexity, and fragility of PCBs, and the associated cost and complexity of the robotic arms and the universal fixtures. Once a robotic arm is programmed it is also extremely difficult to alter the configuration of the operating modules between which the robotic arm is tasked to repetitively perform. Furthermore, neither the robotic arms nor the universal fixtures have achieved much success with reducing the amount of time required to load and position the fixture assembly, load and position the PCB with respect to the fixture assembly, make the electrical connection with the PCB, remove the PCB from the fixture assembly, and prepare the test system for testing the next PCB (especially if the next PCB has a different configuration).

US-A-4,348,276 describes an automatic testing apparatus for automatically testing, adjusting and sorting PCBs of a single specific type, at any one time, in a predefined, fixed sequence determined by the physical arrangement of test stations along an one-way conveyor system. PCBs are introduced into the apparatus through a casing and placed onto a pallet. The pallet passes first into a parts testing device, where the components of the PCB are tested, then into each of two parts measuring/adjustment devices. If any failures are found, the PCB is transferred to an unfit parts conveyor. Consequently, this known testing apparatus is specific to a single given product type at any given time and limited to a particular, fixed process sequence at all times. It does not represent a flexible automation system capable of processing PCBs of different types concurrently and does also not include a provision for repair of PCBs within the system. The failed PCBs requiring repair simply disappear.

In case that different types of PCBs have to be tested it becomes necessary to change a Read Only Memory and data of the memory circuit. This requires replacement of the program memory and predict data. Thus, in order to process a different PCB type significant changes have to be made to the apparatus, including changing the ROM in each of the measuring/adjustment devices and manually exchanging the pallets, adjusting the casing, the circuit board take out device, the parts testing device and each measuring/adjustment device.

In an automatic test system for PCBs disclosed in EP-A1-0 050 014, different types of faulty PCBs are identified by individual codes relating to faulty component parts of the circuit to be tested and, if the case may be, repaired. A bar code serial number of a faulty PCB presented for repair can be read by an optical code reader being connected to a controller unit. The system, however, is adapted to assist an operator in performing testing and repair of PCBs, it does not work automatically without the operator's control.

The problem to be solved by the invention is to provide a flexible automation system capable of processing PCBs of different types concurrently and including provisions for repair of PCBs within the system, the apparatus having flexibility in routing PCBs between different stations of the system and capability for controlling such transport in accordance with a predetermined process sequence file for each type of PCB entered into the system to accomodate the test and/or repair of PCBs of different types concurrently.

This problem is solved by an automated multi-station system as indicated in claim 1 as well as by a method for automating test and/or repair operations to be performed on PCBs as indicated in claim 18.

## SUMMARY OF THE INVENTION

The present invention proposes an apparatus and a method for testing and/or repairing PCBs which substantially minimizes the aforementioned limitations and which can be used to automatically select, transport, and load the fixture assembly or comparable circuit means required to test or repair a given PCB ; transport and position the PCB to be tested or repaired with respect to the circuit means ; electrically connect the same to the circuitry adapted to selectively test the electrical circuits of the PCB ; test the PCB by stimulating various nodes within the circuits of the PCB with a predetermined signal and measuring the response of the electrical circuit to the signal; determine in view of an interpretation of the test results whether the PCB being tested is acceptable, defective, or requires additional testing or repair ; conduct the additional tests or remove the PCB from the circuit means and transport the PCB to another area within the test or repair system corresponding to the determined status of the PCB ; determine whether there are other PCBs to be tested or repaired which will utilize the same circuit means presently loaded within the test system. and if so, sequentially transport and position one of such PCBs with respect to the circuit means or otherwise unload the circuit means ; and determine whether there are other PCBs to be tested or repaired which require a different circuit means, and if so, select and load the appropriate circuit means, etc. It should be emphasized that the system according to the present invention is not strictly limited to testing PCBs. As will become apparent, stages can be advantageously included within the system to manufacture or repair PCBs, e.g. to insert or remove parts, to make adjustments to parts, to solder or unsolder parts, to burn in parts, etc. To emphasize the availability of these alternative operations, this disclosure utilizes the terminology "test and/or repair" to generically refer to such operations. For the sake of brevity and readability such alternative language has not, however, been repeated in each and every instance. The failure, therefore, to specifically refer to both terms should not be viewed as intentionally limiting the reference, for example, to strictly test operations.

The testing and/or repair of a PCB may require multiple stages and, therefore, the movement of the PCB from one stage to another. Conveyor means are provided to efficiently and accurately load a PCB, for example, onto a selected test stage prior to the test and for removing the PCB from the test stage after the test. In the preferred embodiment of the system according to the present invention, the system further includes control means to efficiently route the PCB through the various stages required to test and/or repair a given PCB. In its preferred embodiment the present invention further includes mounting the PCB within a carrier which is adapted to uniquely position and restrain the PCB therein. The carriers are adjustable to accommodate various shapes and sizes of PCBs and are adapted to facilitate the movement of the PCBs into and out of the various test stages of the test system by the automated conveyor means. The carriers include structure which in cooperation with other components of the test system facilitate the precise positioning of the PCB with respect to the circuit means.

## DESCRIPTION OF THE ACCOMPANYING DRAWINGS

The present invention will be further described hereinafter with reference to the accompanying drawings wherein :

Figure 1 is a perspective view of a testing system according to the present invention ;

Figure 2 is a perspective view of a carrier according to the present invention ;

Figures 3 and 4 are partial sectional views taken along lines 3-3 and 4-4 respectively, of Figure 2 ;

Figure 5 is a partial end view of a conveyor according to the present invention ;

Figure 6 is a perspective view of an automation interface according to the present invention ;

Figure 7 and 8 are partial sectional views taken along lines 7-7 and 8-8 respectively, of Figure 6 ;

Figure 9 is a perspective view of a fixture assembly according to the present invention ;

Figure 10 is a partial sectional view showing the relative positioning and location of the cover assembly, PCB, carrier, fixture assembly, and circuit mean connecting the same to a test stage ;

Figure 11 is a perspective view of a cover assembly according to the present invention ;

Figure 12 is a perspective view of a buffering stage according to the present invention ;

Figure 13 is a partial section view taken along line A-A of Figure 12 ;

Figure 14 is a functional block diagram illustrating the interconnection of the various modules according to the present invention ; and

Figure 15 is a flow chart illustrating the various steps of a method according to the present invention.

## DETAILED DESCRIPTION OF THE INVENTION

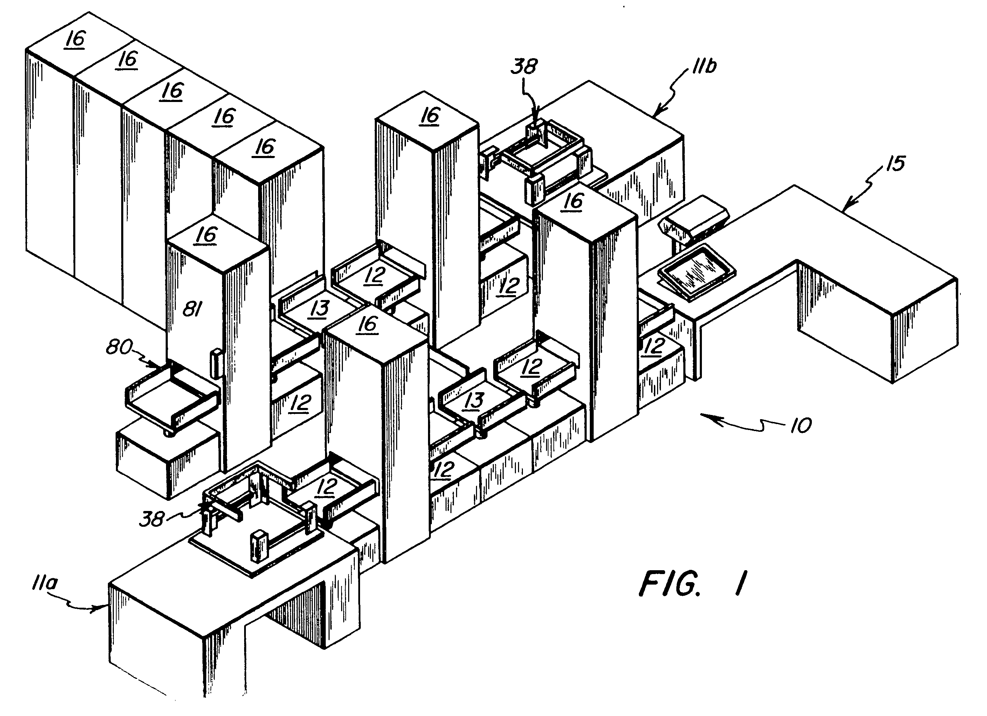

A perspective view illustrating various functional modules of the test system 10 according to the present invention is provided in Figure 1. Depending upon the complexity and type of circuit or PCB being tested it may be necessary to use multiple test stages. It may also be necessary to use various combinations of test stages in different sequence ; to reliably locate the faults which might be present therein. As can be seen, the system 10 can include such multiple test stages, for example, stages 11a and 11b. The test stages 11 can be identical, or they can be of different types, e.g. functional, in-circuit, combinational, special device or component testers, bare board testers, etc. Although Figure 1 illustrates two test stages 11, the present invention is not intended to be limited to this number nor to the descriptions provided above. Conveyor means are provided to load and unload such PCBs from the test and/or repair stages and to transport the PCBs there between. The conveyor means of the present invention are specifically adapted to afford flexibility in the configuration of the test system 10. Conveyor 12 is a linear conveyor which moves the PCB in two directions, i.e., towards as well as away from a stage. It should be noted that such forwards and backwards motion is not commonly found in typical automated production lines which generally transport the items under process in one common direction. A more complex motion is however required to afford conveyor 12 to be utilized to transport a PCB both into as well as out of a test stage 11, as is included in the present invention. To afford an even more flexible test and repair system, conveyor 13 incorporates the capability for the rotational movement of the PCB in addition to linear movement. Various combinations of conveyors 12 and 13 can be utilized to facilitate multiple arrangements of test stages 11 in order to optimize the test system 10 to the particular user requirements. Utilizing different types of conveyors 12 and 13 not only provides increased efficiency, but additionally allows a user to reduce the cost of the test system by utilizing the less expensive linear conveyor 12 for those applications when rotational movement is not required : It also allows the user to easily alter the configuration of the test system 10 as the requirements change.

Stages other than test stages 11 can be included within the test system 10. For example, Figure 1 illustrates a repair station 15, such as a model 404 repair station which is commercially available from the FACTRON/Schlumberger division of Fairchild Camera and Instrument Corporation. This repair station 15 incorporates a repair and adjustment capability as well as a testing capability. A PCB can be diverted to stage 15 when repair (e.g. desoldering and replacement of components) or adjustments (e.g. repositioning of knobs or switches within the PCB) are required prior to completing the testing of the PCB. In addition, manual probing of the PCB may be accomplished such as may be required, for example, to trace a fault indicated as being on a common node having multiple connections thereto.

Buffering or set-up stages 16 are also included to afford a smooth flow in and out of the various test or repair stages. The buffering stages 16 can also be utilized as input and output stages for the test system 10.

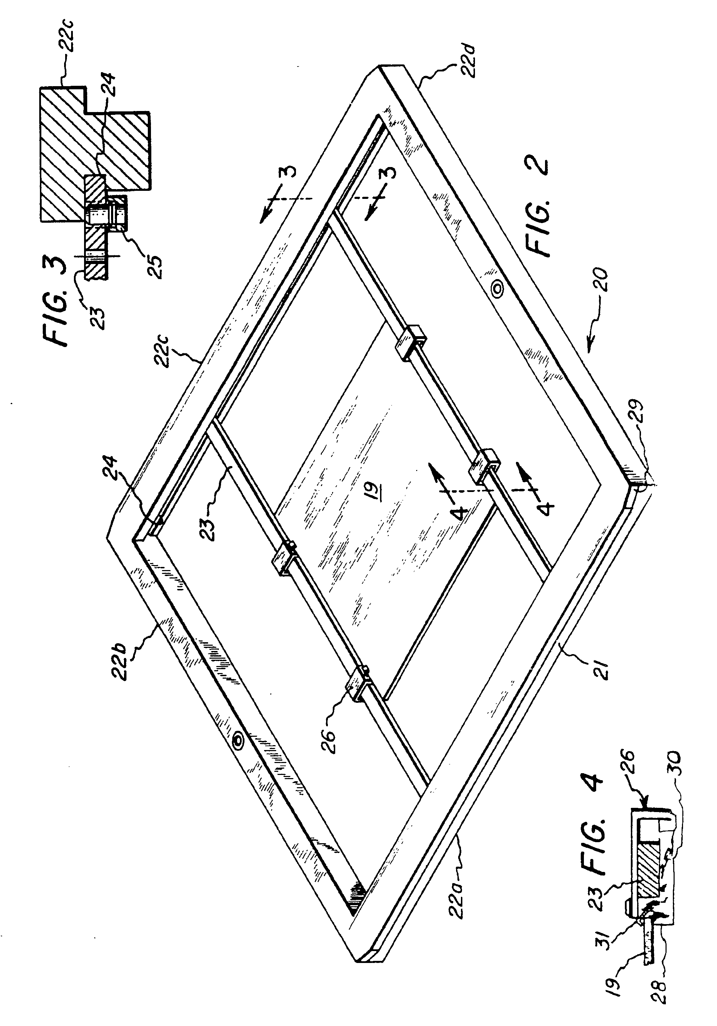

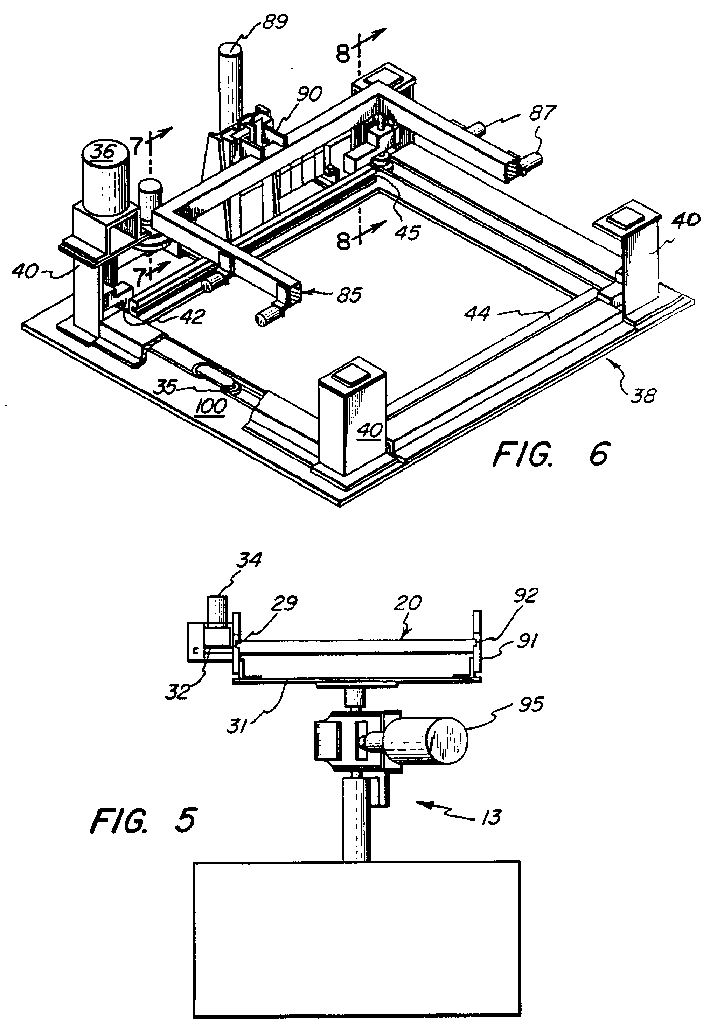

To facilitate the movement of various PCBs throughout the test system 10 the present invention utilizes a carrier 20, which is best illustrated in Figure 2. The carrier 20 is designed to be adjustable to accommodate a wide range of sizes and configurations of PCBs 19. By utilizing adjustable carriers 20 the test system 10 can accommodate various sizes and configurations of PCBs without requiring manual intervention or downtime to adjust the remainder of the test system 10 for a specific size or configuration PCB. By combining this feature with other aspects of the present invention, the test system 10 of the present invention can concurrently accommodate or intermix different PCBs 19, e.g. different shapes and sizes. This is particularly useful and cost effective for users who do not consistently test a large volume of the same PCBs 19. The carrier 20 includes a frame having interconnected members 22 circumscribing and thereby defining an interior area sufficiently large to accommodate the PCBs 19 which are intended to be tested. At least two of the interconnected members 22a and 22c are generally parallel to each other and form opposing supports for two suspension beams 23. The suspension beams 23 are mounted in a manner which facilitates the lateral adjustment of the suspension beams 23 along the members 22a and 22c (See Fig. 3). The interior surface of each of the members 22a and 22c has a longitudinal channel 24 therein which is adapted to loosely receive the distal ends of the suspension beams 23. Such distal ends include a threaded bore having a corresponding set screw 25 engaged therein. Tightening such set screw 25 against one of the side walls forming such channel 24, which side wall is extended to overlap such bore, causes the displacement of the beam 23 within channel 24 to a position in which it is frictionally engaged with the opposing side wall of the channel 24. Loosening such set screw 25 affords the movement of the suspension beams 23 within the channels 24. The beams 23 can thus be displaced with respect to each other to accommodate varying lengths (or widths) of the PCB. One or more support brackets 26 are adjustably mounted on each of the beams 23 and adapted to engage the edges of a PCB 19. The brackets 26 (see Fig. 4) include springs 30 which can be biased toward the beams 23 to frictionally engage the beams 23 but which can also be pivoted to a position spaced from the beams 23 to release the brackets 26 from frictional engagement with the beams 23 and afford the movement of the brackets 26 along the beams 23 in order to adjust for differing sizes and shapes of PCBs. The edge of the brackets 26 which is proximate to the PCB 19 has a groove 28 therein which is adapted to receive an edge of the PCB 19. Similarly, the proximate end 31 of the spring 30 is also adapted to receive this edge of the PCB 19. The bracket 26 is designed such that the absence of a PCB 19 will allow the spring 30 to pivot toward its spaced position thereby releasing the beam 23. The insertion of a PCB 19 between the proximate end 31 of the spring 30 and the groove 28, however, biases the spring 30 to engage the beam 23. The resilience of the spring 30 also securely captures the PCB 19 between the groove 28 and the proximate end 31 of the spring 30. Since a typical PCB may have components mounted at varying positions adjacent its outer edge it is possible with the present invention to adjust the brackets 26 along the beam 23 to a position which minimizes interference with these components. The parallel side members 22a and 22c also facilitate the transport of the carrier 20 by the conveyors 12 and 13. For this purpose at least one surface 21 of the generally parallel side members 22a and 22c of the carrier 20 is substantially planar and has a coefficient of friction promoting the transport of the carrier 20 by the conveyors 12 or 13. Furthermore the side members 22a and 22c include a projecting ridge 29, the operation of which, as well as the operation of the planar surface 21 will become apparent as a result of the description of the conveyors (supra). Each of the carriers 20 also contain structure to accurately locate the carriers 20 when they are positioned within any of the various stages 11 or 15 making up the system 10, as will be explained. In the embodiment illustrated the location holes 27 provide this locating structure.

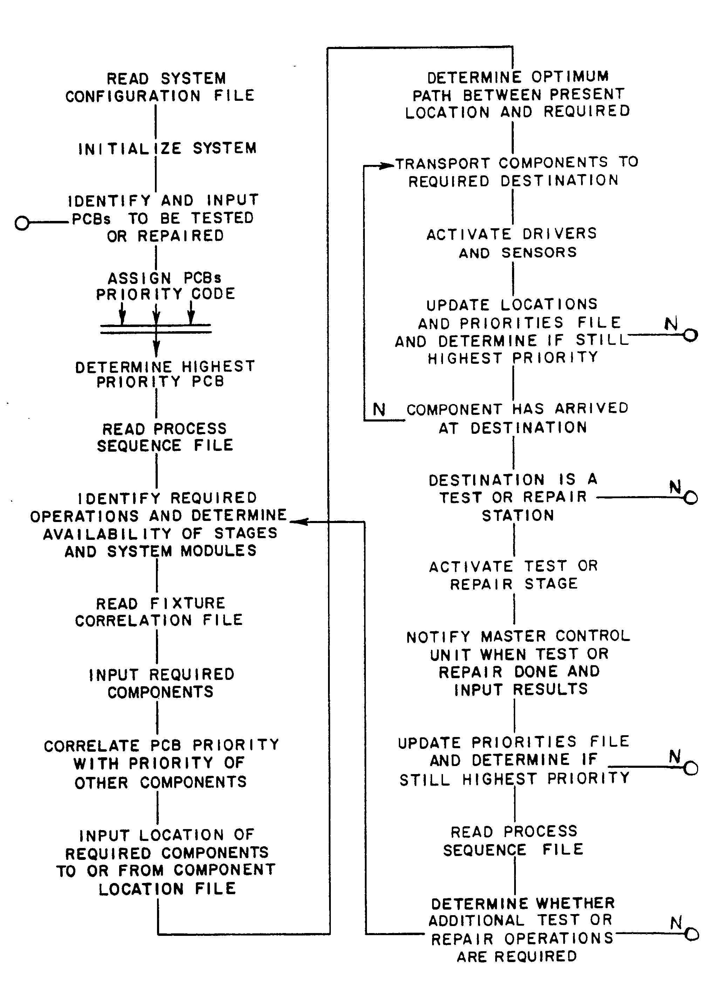

As has already been discussed the conveyors 12 and 13 provide for the transport of the carriers 20 and the PCBs therein between the various stages 11 and 15 of the test system 10. Although a variety of drive means can be utilized to transport the carriers 20, the illustrated embodiment (See Fig. 5) employs driven rollers 32 which establish frictional contact with the planar surface on the members 22a and 22c of the carriers 20. The rollers 32 are driven in a conventional manner by a dc motor 34. The driven rollers 32 are supported on chassis 31 in a conventional manner and positioned adjacent both the opposing ends of the conveyors 12 or 13 to maintain control over a transported carrier 20 as it passes in either direction into or out of one conveyor 12 or 13 to an adjacent conveyor 12 or 13, or into and out of a test stage 11 or a repair stage 15, as is applicable. The direction of travel of the rollers 32 is determined by the polarity of the dc motor 34. Guide rails 91 also supported upon the chassis 31 in a conventional manner and located adjacent opposing sides of the path of the carrier 20 contain channels 92 which are adapted to receive the projecting ridges 29 of the carriers 20 thereby guiding as well as supporting the carriers 20. In order to change the direction of transport by other than 180 degrees, the conveyor 13 includes a stepper motor 95 and associated conventional bearing and gearing mechanisms or their equivalent (not shown), to rotate the chassis 31 supporting the rollers 32. The dc motor 34 and therefore the driven rollers 32, as well as the stepper motor 95 are microprocessor controlled to afford flexibility in the path along which, and the speed at which a given carrier 20 is transported, as well as accurate control of the movement of the carrier 20 or whatever other components are being transported. Conveyor 12 and conveyor 13 are substantially identical except that conveyor 12 excludes the stepper motor 95 and its associated mechanisms. Each of the conveyors 12 and 13 also includes appropriate sensors (See Fig. 14) to determine the presence and location of a carrier 20 or other transported component therein. Similarly sensors also determine the relative positioning of the chassis 31 of the rotable conveyor 13. This can be accomplished with mechanical, optical, magnetic, capacitive, or other type of conventional sensors. If the test system 10 requires a conveyor to stop or hold the transport of a carrier 20 or other transported component, stop solenoids are also provided at the entrance and exit ends of such conveyors. When actuated the moveable element of such solenoids is interposed within the path of the carriers 20 to prevent further motion. The conveyors 12 and 13 are adapted to be utilized in modular form. For example, one of the conveyors 13 can contain a conveyor controller or microprocessor (See Figure 14) which can provide control for some predetermined quantity of slave conveyors 12. These slave conveyors 12 can simply be plugged into the master conveyor controller and such controller can be programmed with the location and identity of the additional conveyors 12 and 13 being utilized within the test system 10 and plugged therein, thereby avoiding the need for redundant microprocessors within each of the slave conveyors 12. Each slave conveyor will, however, contain drivers, sensors, and stops to the extent required, such as have been described above.

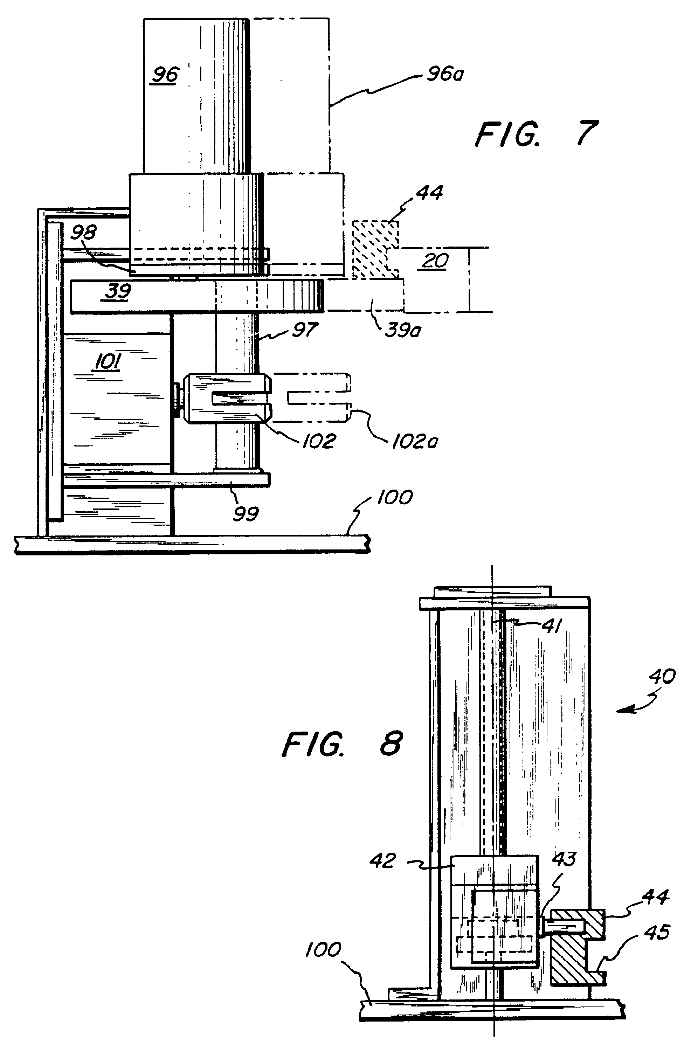

The conveyor means also includes an automation interface 38 (See Fig. 6) which interfaces the test and repair stages 11 and 15 with the conveyors 12 or 13. The automation interface 38 of the present invention is adapted to be utilized with existing testers such as are now commercially available. The automation interface 38 contains driven rollers 39 similar to those utilized by the conveyors 12 and 13. The driven rollers 39 are positioned to engage the parallel side members 22a and 22b (See Fig. 7) of the carriers 20 as the carriers 20 exit from the conveyors 12 or 13. In this manner the rollers 39 can maintain control of the carriers 20 when the rollers 32 of the conveyors 12 or 13 have lost effective control. The driven rollers 39 are driven by dc motor 96, which is also under microprocessor control. DC motor 96 is mounted upon a supporting column 97 by a bracket 98. The supporting column 97 is in turn rotatably mounted upon a bracket assembly 99 which is affixed to the frame 100 of the automation interface 38. Also mounted upon the bracket assembly 99 is a solenoid 101 or similar device which can be actuated to extend an arm 102 to the position indicated by 102a (as shown by dashed lines). The arm 102 is pivotably connected to the supporting column 97. Therefore, the extension of the arm 102 will rotate the column 97. Such rotation of the column 97 will pivot the dc motor 96 to a position 96a where the driven rollers 39 pass through an opening within the rails 44 and frictionally engage the carriers 20. Similarly the retraction of the arm 102 will disengage the driven rollers 39 from the carriers 20. The automation interface 38 further contains elevator means 40 (See Fig. 8) upon which the driven rollers 39 are mounted and which is adapted to raise and/or lower the carriers 20 with respect to the operating level of the conveyors 12 or 13. In the preferred embodiment the elevator means 40 comprise two spaced rails 44 which are substantially parallel to each other. Each of the rails 44 contains a longitudinal channel 45 therein which is adapted to receive and support the projecting ridge 29 extending along the side members 22a and 22c of the carriers 20. The rails 44 are themselves supported on air cylinders 43 or the like which afford the relative movement of the rails 44 from a position supporting the carriers 20 to a position where the rails 44 are spaced from the carriers 20. The air cylinders 43 are in turn supported by the shuttle members 42 of lead screw mechanisms 41, and the lead screw mechanisms 41 are driven by a stepper motor 36 which is microprocessor controlled. A drive belt 35 in combination with various pulleys are driven by motor 36 and in turn drive lead screw mechanisms 41 located at each of the opposing corners of the rails 44. Rotation of the multiple lead screw mechanisms 41 by the motor 36 will raise or lower the rails 44 in a controllable manner. The rails 44 can therefore be positioned at the operating level of the conveyors 12 and 13, and the air cylinders 43 can be actuated to move the rails 44 to the position at which they can support the carriers 20. In addition solenoid 101 can be actuated to bring the driven rollers 39 into frictional engagement with the carrier 20. A carrier 20 can then be transported by the driven rollers 32 of the conveyors 12 or 13 and/or the driven rollers 39 of the automation interface 38 into the channels 45 of the rails 44. Conventional mechanical stops or solenoids (See Fig. 14) can be utilized to ensure the carrier 20 is fully transported and accurately positioned within the rails 44. The solenoid 101 can then retract the driven rollers 39 and the lead screw mechanisms 41 can be driven to raise or lower the carrier 20 from the operating level of the conveyor 12 or 13 to the operating level of the repair or test stage 11 or 15. The automation interface also includes appropriate sensors (See Fig.14) similar to those described with regard to the conveyors to determine the presence of a carrier 20 or other transported article therein. Similarly, sensors are also available to determine the positioning of the elevator means 40 and the rails 44.

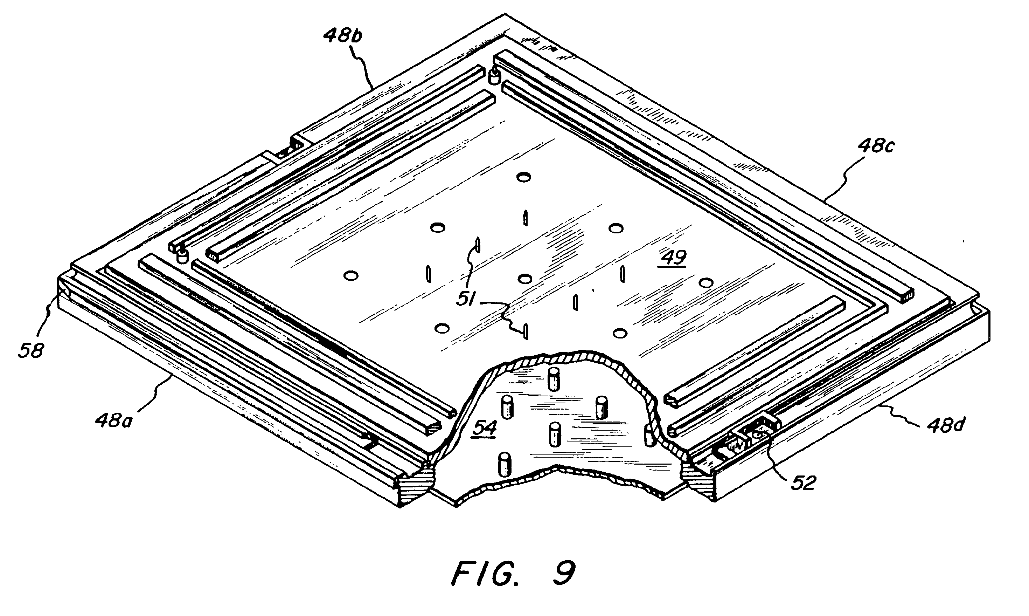

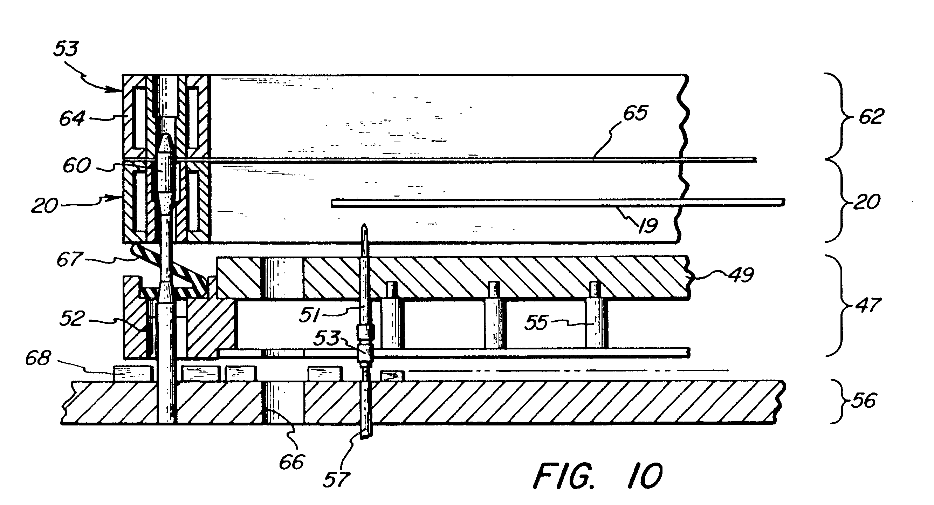

As has already been stated, PCB testers traditionally use fixturing assemblies to achieve electrical contact with the PCBs under test. Traditionally, these fixture assemblies are manually loaded onto the testers and the probes therein are electrically connected to the various stimulus and measurement means included within the testers. The PCBs which are to be tested are then individually and manually placed upon such a fixture assembly and accurately located with respect to the probes. A detailed discussion of a fixturing system such as is described above is set forth in U.S. Patent 4,352,061 (hereinafter "061 Patent"), which has a common assignee with the present invention. Such a fixturing assembly as is taught by the 061 Patent can be adapted to permit its transport by the conveyor means 12 and 13. As is best illustrated in Figures 9 and 10, the fixture assemblies 47, adapted according to the present invention, include a frame having interconnected members 48a-48b circumscribing and thereby defining an interior area sufficiently large to accommodate the larger PCBs which are intended to be tested. The frame 48 has at least 2 parallel side members 48a and 48c adapted to afford the transport of the fixture assembly 47 by the conveyers 12 and 13. For this purpose at least one surface on each of the parallel side members 48a and 48c of the fixture assembly 47 is substantially planar and has a coefficient of friction which will promote the transport of the fixture assembly 47 by the conveyor means 12 or 13. Side members 48a and 48c also include a projecting ridge 58 which will be received by the aforementioned channels 45 and 92 of the conveyor means. In addition, location holes 52 similar to those described within the carrier 20 are also added to facilitate locating the fixture assembly 47 with respect to the automation interface 38. Supported within the frame 48 is a non-conductive plate 49. Typically this plate 49 is manufactured from materials having characteristics resulting in a plate 49 which is both lightweight and yet capable of withstanding substantial forces without significant deformation. One such material is manufactured and sold by General Electric Company under the designation G-10 epoxy glass cloth, although comparable glass, paper or cloth laminates are also useable. A predetermined array of electrical probes 51 are supported within and pass through this plate 49. These probes 51 are positioned in a pre-arranged pattern to correspond with selected nodes on the PCB 19 which is to be tested. As has already been described, this pattern will typically be unique for each type or model of PCB 19 which is to be tested. The array of probes 51 is electrically connected to an array of posts 53 which are supported within a contact panel plate 54. Either individual wiring or a personality or universal matrix platen concept such as is described in the 061 Patent could be utilized to provide this electrical connection. The contact panel plate 54 is also constructed from materials similar to those described with respect to plate 49, and is similarly affixed to the frame 48. Spacers 55 between plate 54 and plate 49 ensure that plates 54 and 49 remain substantially parallel and rigid. The test stages 11 and 15 contain a receiver 56 also having an array of probes 57 which correspond to the array of posts 53. The probes 57 of the receiver 56 are electrically connected to the various stimulus and measurement means included within the test stages 11 and 15. Actuating means (not shown) such as the vacuum described in the 061 Patent are utilized to draw the posts 53 of the contact panel 54 toward the probes 57 of the receiver 56 thereby establishing electrical connection between the probes 57 of the receiver 56 and the posts 53 of the fixture assembly 47. Alternative actuating means (not shown) such as electronic motors, hydraulic cylinders, lever mechanisms, camming mechanisms, etc. can also be utilized to establish this electrical connection.

In a manner already described with regard to the carriers 20, the fixture assemblies 47 can be transported by the conveyors 12 and 13 to a desired automation interface 38 of the required stage 11 or 15. Similarly the elevator means 40 of the automation interface 38 can be used to raise or lower the fixture assembly 47 from the operating level of the conveyors 12 and 13 to a level where the contact panel plate 54 can be brought into preliminary engagement with the receiver 56. Simultaneously the air cylinders 43 supporting the rails 44 can be actuated to cause the rails 44 to release the projecting side members 49 of the fixture assemblies 47. The exact positioning of the fixture assemblies 47 with respect to the stages 11 and 15 is achieved by including guide columns 60 within the test stages 11 and 15. These guide columns 60 cooperate with the location of the location holes 52 within the fixture assembly 47 to accurately position the fixture assemblies 47. Preferably either the columns 60 or the holes 52 are tapered to ensure engagement.

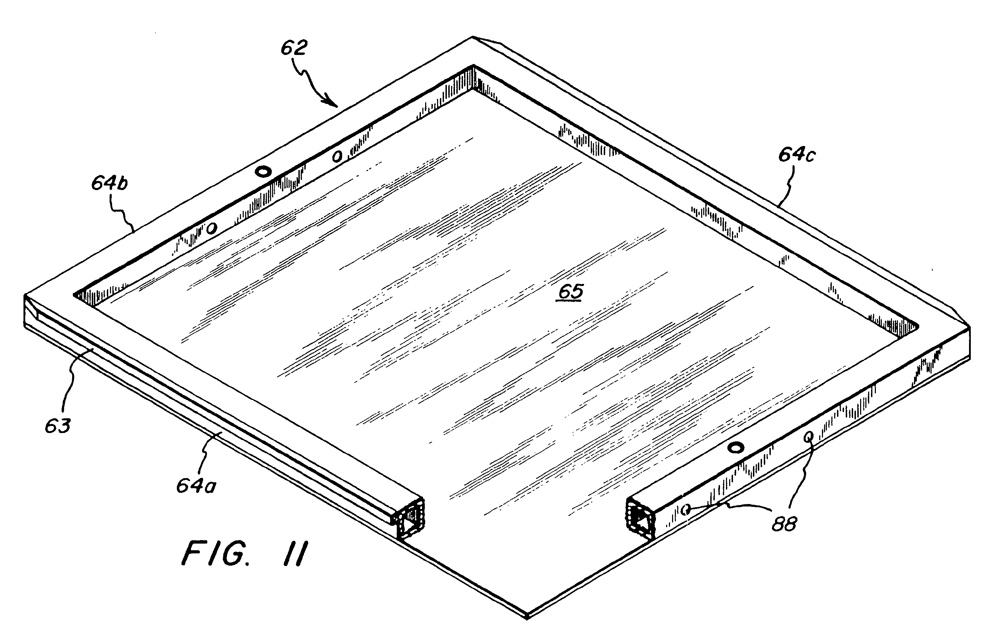

A PCB 19, positioned within a carrier 20, can then be transported to the test stage in a manner already described and positioned upon the fixture assembly 47. Once the PCB is loaded upon a fixture assembly 47, the test systems' actuating means, e.g. a vacuum, is utilized to draw the PCB 19 and the fixture assembly 47 toward the receiver 56 and thereby compress the spring loaded probes of the fixture assembly 47 to ensure electrical connection between the fixture assembly 47 and the conductive paths of the PCB 19. To ensure that a vacuum can be drawn between the PCB 19 and the fixture assembly 47 the preferred embodiment of the present invention utilizes a cover assembly 62 (See Fig. 11) which includes a frame having interconnected members 64a-64d circumscribing and thereby defining an interior area sufficiently large to accommodate the PCBs 19 which are intended to be tested. At least two of the interconnected members 64a and 64c have at least one surface which is substantially planar and which has a coefficient of friction promoting the transport of the cover member 52 by the conveyors 12 and 13. Side members 64a and 64d also include a projecting ridge 63. Suspended across within the frame 63 is a sealing diaphragm 65 which is constructed of a resilient material such as that utilized in the construction of surgical gloves. This diaphragm 65 is supported within the frame 64 in a manner restricting passage of the atmosphere between the frame 64 and the diaphragm 65. The diaphragm 65 is adequately elastomeric such that it is capable of enveloping the PCB 19 in a manner similar to shrink wrap packaging, without damaging the components on the PCB or without itself becoming damaged. The use of such cover assembly 62 affords the elimination of custom edge seals and gaskets which are required by conventional fixtures. In a manner already discussed, the cover assembly 62 can be transported by the conveyors 12 and 13 to an appropriate stage 11 or 15.

Since the cover assemblies 62 are not PCB specific and will function with practically all PCBs 19 and fixture assemblies 47, the automation interface 38 of the present invention is adapted to include separate lifting means (See Fig. 6) for the cover assemblies 62. These lifting means include a lifting carriage 85 having interconnected members forming a substantially U-shaped configuration. Two legs of the carriage 85 are substantially parallel and have solenoids 87 (or comparable devices) mounted thereon which are adapted to engage cover support holes 88 within the frame 64 of the cover assembly 62. The lifting carriage 85 is supported on an air cylinder 89 and slide mechanism 90. Once a cover assembly 62 has been transported to a given automation interface 38, the carriage 85 can be lowered over the cover assembly 62, and the solenoids 82 can be actuated to engage the support holes 88, thereby locking the cover assembly 62 to the carriage 85. The air cylinder 89 can then be actuated to lift the cover assembly 62 within the slide 90 above the operating level of the conveyor, thereby clearing the path for the transport of additional carriers 20 and fixture assemblies 47 without requiring the unloading and transport of a cover assembly 62 for every change in carriers 20 or fixture assemblies 47. Obviating the need to repetitively transport a cover assembly 62 between an automation interface 38 and a buffering stage 16 further reduces the time taken by the system 10 of the present invention to test and/or repair PCBs. To facilitate the vacuum seal, either the frame 64 of the cover assembly 62 or the frame 22 of the carrier 20 contains appropriate gasket means to create a seal between the carrier 20 and the cover assembly 62 when the two are placed adjacent to one another. In the preferred embodiment the diaphragm 65 is extended over the frame 64 to provide such gasket means. Similarly either the frame 21 of the carrier 20 or the frame 48 of the fixture assembly 47 will also contain appropriate gasket means 67 to seal the space there between when the carrier 20 (and PCB 19) is placed upon the fixture assembly 47. Likewise gasket means 68 are interposed between the fixture assembly 47 and the contacting surface of the test stage 11 or 15. It is apparent to one skilled in the art that such gasket means in cooperation with the cover assembly 62 will facilitate a sealed chamber which can be evacuated in order to draw the diaphragm 65 downward in response to the greater atmospheric pressure above the diaphragm 65 resulting from the vacuum, and thereby force the PCB 19 and the fixture assembly 47 toward the receiver 56. Suitable sensors (not shown) are included with the present invention to ensure the presence of an adequate vacuum, which is also an indication that the fixture assembly 47 and the PCB have been drawn into contact.

It should be noted that the system 10 of the present invention can also be utilized with double-sided PCBs, i.e. PCBs which have nodes on both opposing surfaces which must be accessed in order to test the PCB. In this event a second fixture assembly 47 is transported and positioned adjacent the PCB to be tested, i.e. the PCB is sandwiched between the two fixture assemblies. In the preferred embodiment the array of probes 51 of the upper fixture assembly 47 are electrically connected to an array of posts 53. Such posts 53 of this upper fixture assembly are, however, supported in plate 59 exterior to that portion of its surface area which is directly opposite the PCB when the PCB is positioned adjacent thereto. In addition the lower fixture assembly 47 contains an array of probes 51 which are adapted to contact the posts 53 of the upper fixture assembly when the vacuum or other actuating means draws the various components together.

It should be noted that circuit means other than the fixture assemblies 47 thus far described can be utilized as part of the present invention to achieve electrical contact with the selected nodes of the PCB to be tested.

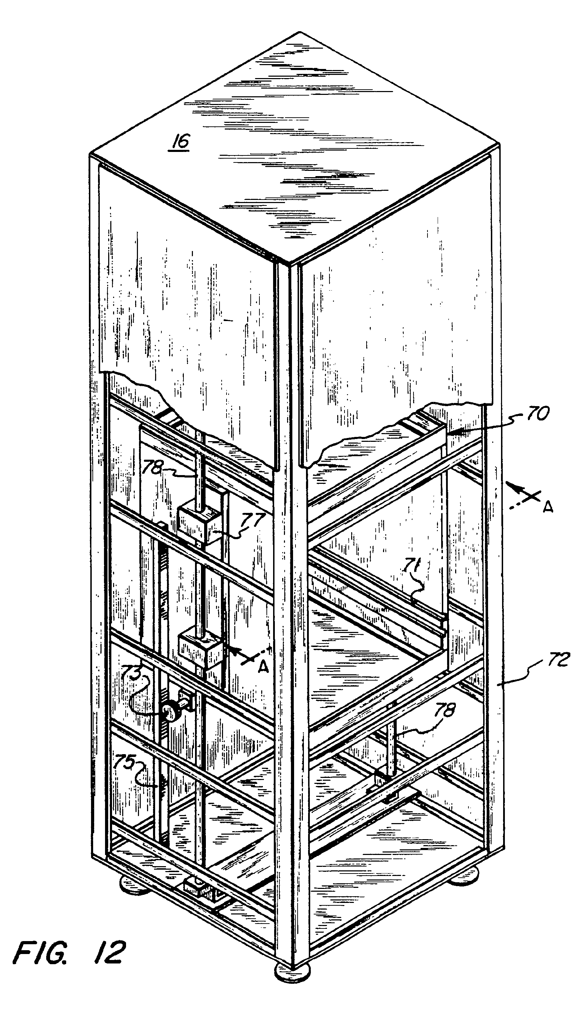

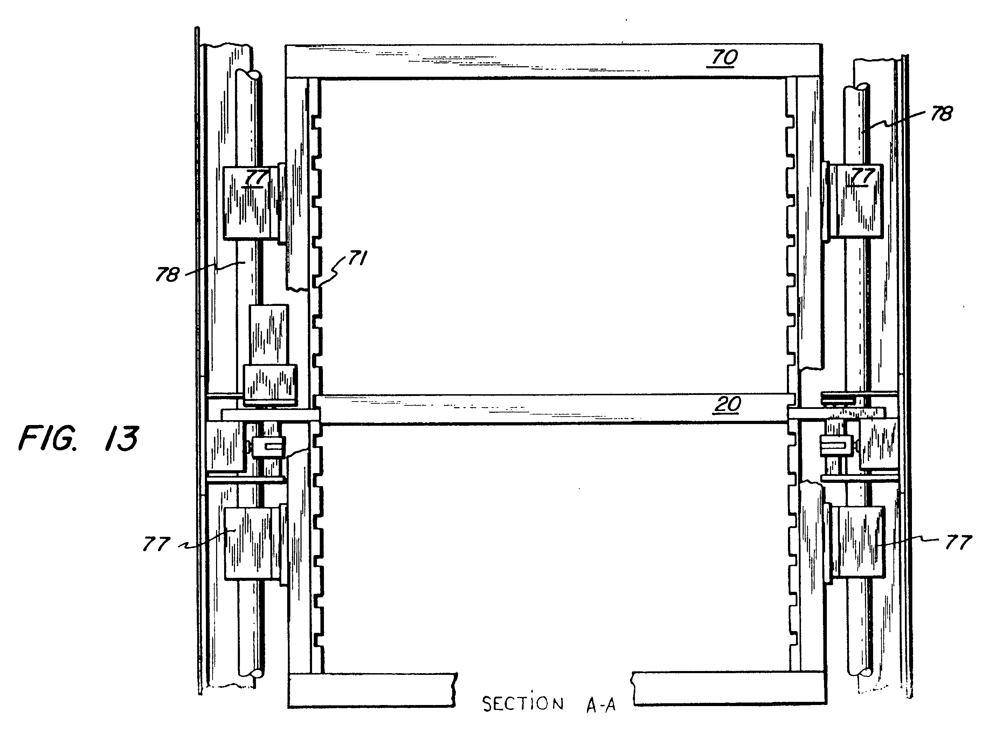

As has previously been discussed the present invention includes one or more buffering stages 16 which are used as component input/output devices for the test system 10. Such buffering stages 16 (See Figs. 12 & 13) include a large receptacle 70 having internal wall portions 71 forming a plurality of slots or cells adapted to receive and support the carriers 20, the fixture assemblies 47 and the cover assemblies 62, in a manner permitting them to move interchangeable in or out of the receptacle 70. The receptacle 70 is supported within a frame 72 so as to be moveable in a generally upward or downward direction with respect to the operating level of the conveyors 12 or 13. Typically this movement is achieved by driven pinion gears 73 rotatably mounted on opposing sides (only one is shown) of the receptacle 70. The pinion gears 73 are driven by a conventional stepper motor (not shown). Corresponding slotted racks 75 which are adapted to engage such pinion gears 73 are fixed to the two adjacent sides (only one is shown) of the frame 72. In this manner the rotation of the pinion gears 73 by the stepper motor will move the receptacle 70 in either an upward or downward direction, to afford the positioning of the receptacle 70 with any preselected one of its cells at the operating level of the conveyors 12 or 13. To facilitate the accurate and aligned movement of the receptacle 70 it is mounted with respect to the frame 72 by a plurality of bushings 77 slideably supported on columns 78 which are in turn affixed to frame 72. The buffering stages 16 also contain two drive wheels 76 driven by a dc motor (not shown) in the same manner as previously been described with respect to the conveyor means. These drive wheels 76 are pivotally mounted on frame 72 at the operating level of the conveyors 12 and 13. To afford the up and down movement of the receptacle 70 within the frame 72, a solenoid 79 or comparable device is used to pivot the drive wheels 76 in a manner similar to that described with regard to the automation interface 38, from a position at which they are in frictional contact with the parallel side members of either the carrier 20, the cover assembly 62, or the fixture assembly 47 which is within the cell or the receptacle 70 positioned at the operating level of the conveyors 12 and 13, to a second position which is spaced from the receptacle 70. It should be noted that the receptacle 70 contains cut out portions within the wall portions 71 defining each cell to permit the drive wheels 76 to intrude within the interior of the receptacle 70 so as to contact the various carriers 20, fixture assemblies 47 and cover assemblies 62 located therein. The motors of the buffering stage 16 are also microprocessor controlled to facilitate the exact positioning of the receptacle as well as the timely pivotal action and rotating of the drive wheels 76. Appropriate sensors of the types already described are included (See Fig. 14) to determine the presence of a carrier 20 or other transported article within the cells of the receptacles 70. Similarly sensors also determine the relative positioning of the receptacles 70 and the drive wheels 76.

It should be noted that buffering stages 16 are also designed to be modular, and a variety of configurations are therefore possible. For example multiple slave buffering stages 16 can be stacked adjacent one another for mass storage of cover assemblies 62, fixture assemblies 47, and carriers 20. In this configuration it is useful to have separate drive wheels 76 and a corresponding dc motor on the side of the buffering stage 16 proximate to a conveyor, and separate drive wheels 76 and a corresponding dc motor on the side of the buffering stage 16 proximate to adjacent buffering stage 16. This affords more accurate control over the carriers 20, fixture assemblies 47, and cover assemblies 62 as they are being transported between adjacent buffering stages 16. It is also possible with this configuration to utilize a master buffering stage ·controller or microprocessor connected to multiple slave buffering stages (See Fig. 14). This concept has already been discussed with respect to the conveyors 12 and 13. The slave buffering stages while containing similar motors, sensors, and stops, do not require separate microprocessors. Alternatively, or in addition, buffering stages 16 can be utilized as input devices to individual repair or test stages. This configuration can shorten overall testing and repair time since, as an example, a batch of carriers 20 containing PCBs 19 requiring the same fixture assembly 47 can be stored proximate a given test stage and immediately sequenced through that test stage as it becomes available. In this configuration it is useful to have separate drive wheels 76 and a corresponding dc motor operating at different vertical levels within the buffering stage 16. For example components could enter and exit the buffering stage 16 from or to an adjacent conveyor at the conveyor operating level, while at the same time entering from or exiting to an adjacent test stage at the operating level of such test stage.

When the test system 10 according to the present invention is initially installed the User will be required to identify certain information about the system configuration and the PCBs that are to be tested and/or repaired. This information includes the type of test stages 11, repair stages 15, conveyors 12, conveyors 13, and buffering stages 16 which will make up the system 10, as well as the relative location of each of these modules within the system 10. It is possible with this system 10 to create a large variety of different physical configurations using the standard modules as described. It also seems very likely that an installed system may be modified from time to time for purposes such as the addition of new modules or the creation of additional or alternate paths to high volume modules, etc. In a traditional automation system these changes would require the user to experience a relatively long period of production shut-down in order to make several mechanical and/or software revisions to be able to use the newly configured system. An important benefit of the present invention is that such changes are possible with a minimum of down-time and virtually no software changes. Since this system is comprised of a relatively small set of modules whose functions are known, any configuration of the system can be reduced to a list of modules, their types, and the necessary relationship between them with regard to control and orientation. Rather than force the user to determine the desired layout by paper and pencil methods and later input a fairly large amount of data, the present invention provides a convenient method for arranging the modules of a system and at the same time automatically capture the required data to operate the system 10. During the initial start-up the master control unit 17 presents the user with a grid pattern on a graphical display device, and a menu upon which the various potential modules are represented schematically, e.g. by icons. These icons may be selected by the user and placed on the grid. In this manner a configuration may be built up in an interactive way which represents the desired configuration of the system. The user may remove and replace modules, select new module types, and reconfigure the module orientations until the configuration appears as desired. The configuration may be an entirely new layout, or an existing configuration may be recalled and "edited" to achieve the desired result. A configuration may be "saved" at the request of the user to be used either as the default or controlling configuration file for the new system or as reference when considering more than one possible configuration for the system. Once the desired physical layout has been determined by the user a verification routine may be invoked. The verification routine applies a set of design rules regarding module placements and orientation to be certain that the proposed configuration is operable. An example would be that a corner of the transport system must contain a conveyor 13 with rotation capability. Should an error be located the user is informed of the conflict and the input phase is reinstated. After passing the rule check the user is then prompted for the additional data required to define the configuration which is not ascertainable from the graphic representation, such as controller ID numbers and the desired interconnections of slaves units to master controllers. Once this information is entered a user may request the system 10 to print out a configuration listing. This listing describes the configuration, for example, a list of the modules used by type, a connection list for cables (including power, logic, air, etc.) by module, etc. This listing aids the user in the actual physical connection of a new configuration. By using this interactive method new configurations may be efficiently created by the user, and the resulting data file will automatically contain the required information to allow the system 10 to be controlled without requiring any additional input or changes to the control system software.

Once the configuration is established a software routine within the operating system recognizes the icons and provides each module with a unique identity code (typically based upon the controller ID). The routine then identifies the interconnections between the modules and constructs all the possible paths between the various modules indicated and the required movement of the various modules to facilitate these paths. The operating system utilizes this information to construct a table which correlates all the ways to get from the various starting modules (e.g. buffering stage 16) at which a component may be located to the various destination modules (e.g. test stage 11) to which a component will be transported. Such techniques as are required to formulate this information are commonly available as evidenced by a text entitled, "Computer Algorithms", written by Sara Baase, and published by Addison Wesley, 1978. A file, hereinafter referred to as the system configuration file, is created containing this configuration and path information. This file is stored either in the memory associated with the master control unit or a host computer interfaced with the master control unit, or within a disk file which can be provided as an input to the master control unit when the system 10 is to be used. This modular approach of the present invention and the ease in which configuration changes can be programmed or specified, affords the user flexibility to easily adapt the configuration of the system 10, to tailor the system 10 to the particular user requirements.

Prior to testing and/or repairing PCBs with the system 10, the user is also required to input information pertaining to the various types of PCBs which are to be tested, and the testing process which will be required to test each PCB type. For example, a specific type of PCB might need to be tested first with selected tests on a functional tester. If it fails these initial tests, the PCB may secondarily be tested on an in-circuit tester. If however, the PCB fails certain tests on the functional tester, it may need to be transported to a repair station instead of the in-circuit tester. After repairs and/or adjustments are made to the PCB it may again need to be routed to the functional tester to repeat the tests which it previously failed. Similarly, the existence of certain test results may require the user to perform certain tasks such as manually probing various nodes of the PCB. The PCB would therefore have to be routed to or held at a module affording such tasks. Thus a unique process sequence is determined for each type or batch of PCB which is to be tested. This information is stored as a decision tree or similar device within a file, hereinafter referred to as the process sequence file, which can be provided as input to the master control unit. The decision tree includes the various events which must take place in an established sequence in order to test that PCB type. As is apparent, the tree will typically have multiple branches due to the alternative results which might occur at a given module, e.g. pass, fail, etc.

In addition a file is created which contains a lookup table or similar device correlating a PCB type to a fixture assembly 47 which corresponds to such PCB type. This file, hereinafter referred to as a fixture correlation file, is also provided as input to the master control unit. Also included within the fixture correlation file is a listing of any other components such as cover assemblies 62 or upper fixture assemblies 47 which will be required to test and/or repair that PCB type. Typically the process sequence file and the fixture correlation file will correlate the PCB type to the corresponding components by utilizing a serial number located on the PCB, or carrier holding the PCB, of which certain digits refer to the PCB model or type, and the remaining digits uniquely identify each individual PCB of that type. In the preferred embodiment this serial number can be affixed to a PCB or carrier via a bar code sticker which can be automatically scanned by the test system 10 according to the present invention. The same digits which identify the PCB type can also be used to identify the unique fixture assembly 47 which corresponds to all of the PCBs of this PCB type. Thus once the bar code for a given PCB is scanned, the operating system can search the process sequence file through the master control unit and ascertain the various modules within the test system which will be required to test that particular PCB 19. Similarly the fixture correlation file can also be searched to identify the other components which will be required to test that PCB. A message can be displayed to the operator to make certain that the correct fixture assemblies 47 and, depending upon the size of the batch of PCBs to be tested, an adequate number of cover assemblies 62 and fixture assemblies 47, etc., are loaded within test system 10. The appropriate cover assemblies 62, fixture assemblies 47 and carriers 20 (containing the PCBs 19 which are to be tested) can be individually inserted into the test system 10 or these components can be stored within a buffering stage 16 and automatically transported by the conveyor means. The test system 10 according to the present invention may have one or more buffering stages 16 dedicated to fixture assemblies 47 and/or cover assemblies 62, and one or more buffering stages 16 dedicated to the PCBs 19 to be tested. Such separation of fixture assemblies 47, cover assemblies 62 and carriers 20 is not however necessary and such fixture assemblies 47, cover assemblies 62, and carriers 20 can all be combined within the same buffering stage 16. Regardless of the configuration, the location of each of the various carriers 20, fixture assemblies 47, and cover assemblies 62 must be identified and available as input to master control unit. In the preferred embodiment a file, hereinafter referred to as the component location file, is created containing this component location information and provided as input to the master control unit. In this manner the loading and unloading of the various test stages 11 and 15 and the transport of the various fixturing assemblies 47, cover assemblies 62, and PCBs 19 can be facilitated by the master control unit. It should be noted that the information thus far described as being required as input can be provided through standard input (e.g. keyboards, magnetic storage devices, LAN connections with another computer, etc.) interfaces (See Fig. 14) to the master control unit. Alternatively standards can be developed, requiring for example, that the PCBs to be tested are always placed within a standardized location of a selected buffering stage 16, and the fixture assemblies 47 and cover assembly 62 which are to be ·utilized with the PCBs under test are similarly placed in a standardized location within a specified buffering stage 16.

In the preferred embodiment of the present invention, a component insertion station 80 is included within the system 10. The basic insertion station 80 comprises a conveyor 12 combined with a bar code reader 81. Since the carrier 20, the fixture assembly 47 and the conveyor assembly 62 all have the same outer configuration, the input station 80 can be utilized to as an input/output device for all components. Accordingly, a bar code can be placed on all components to provide an identity to the master control unit. Upon insertion of a component into the insertion station 80, the bar reader 81 would scan the component and input the serial number associated with the component to the master control unit. The master control unit could then ascertain a destination for the component, e.g. an empty cell within a buffering stage 16, by interrogating the appropriate sensors and directing the conveyor units to transport the component to that cell. The identifying number for the component and a code identifying the destination, e.g. the buffering stage 16 and the particular slot within that stage are stored in the component location file. As the components are processed by the system 10 this component location file is dynamically updated to provide an indication of the current location of each of the components.

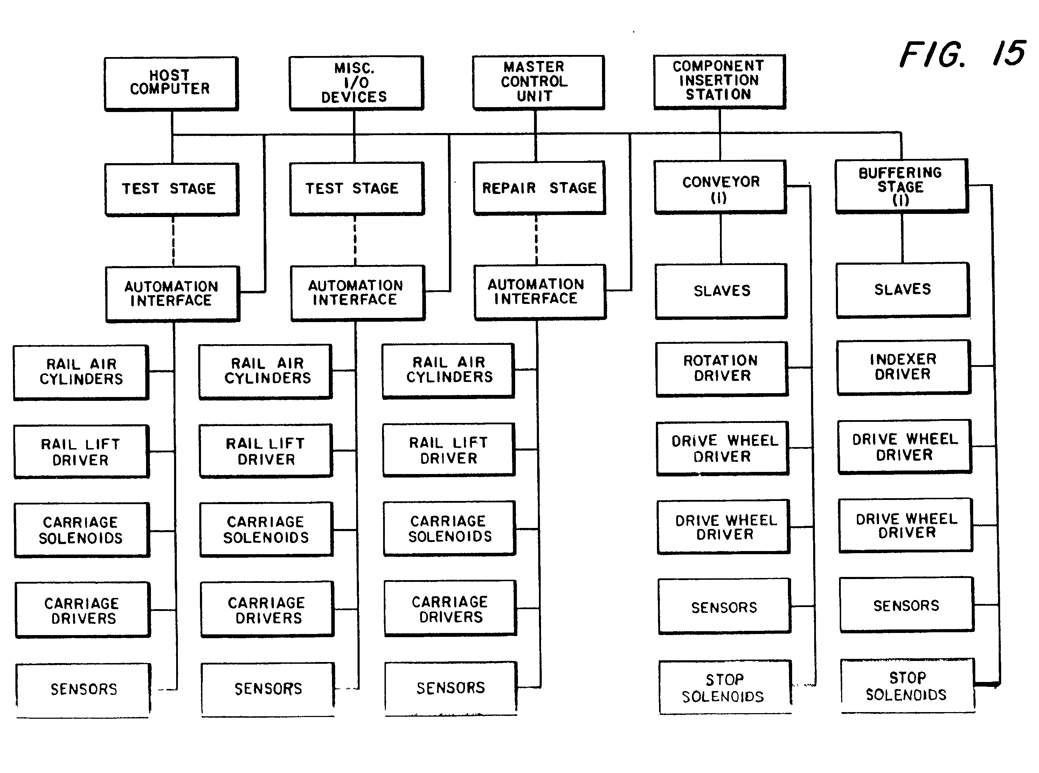

Reference is now made to Figures 14 and 15. During start-up of the test system 10 the master control unit reads the system configuration file to determine what modules exist within the test system 10 as well as their functions and relative locations. The master control unit then initializes the system configuration by interrogating each of these various modules over the network 14 and determining whether the modules are on-line and functioning. If a particular module is not functioning the user is so informed. This module can then be mapped out of the system or the malfunction can be corrected as determined by the user. The control programs for each of the microprocessors located within the various modules are then downloaded from the master control unit. The preferred embodiment of the present invention utilizes substantially identical microprocessors in the various modules and stores the specific control programs for the various types of modules in memory or in a file which can be down loaded to the various microprocessors as required. Each of the microprocessors is equipped with a ROM based monitor program which executes on power-up and readies the microprocessor to receive commands over the network 14. The specific control programs which are downloaded are dependent upon the configuration of the system and the desired function of the specific modules employed. This concept along with the master/slave concept already discussed with regard to the conveyors and the buffering stages affords the user lower costs and added flexibility for easily reconfiguring the system to tailor it to the particular requirements present. Furthermore it eliminates the need for fixed memory or disk drives at each module. Once the various control programs are loaded, the moveable members of the various modules are "homed" to known positions, and the appropriate sensors are interrogated to ensure that such homing has occurred. After every module has been checked and initialized in this manner the user is informed that the system is ready for use.

Testing and/or repair of PCBs within the test system 10 is done on a priority basis, with the intent of keeping the test and repair stages occupied to the fullest feasible extent. When a PCB is entered into the system 10 as previously described it is assigned a priority code which is provided as input to the master control unit. As has been previously stated, the master control unit in combination with the bar code reader has already ascertained the identity of the PCB being supplied to the system 10 for test and/or repair. Through one of the various input devices the user is then requested to associate a base priority code for the PCB as discussed above. If no value is supplied by the user, the system is capable of assigning a default priority code. In the preferred embodiment of the present invention this priority code is dynamic. That is, a PCB awaiting an operation to be performed at a particular stage or module may have its priority code or rating increased as a function of the time it is waiting. This prevents a PCB from being held at a given stage or module in the system for an unlimited period of time such as might be the case when it is pre-preempted by a large batch of higher priority PCBs. The PCB returns to its base priority after the required operation has been performed at that particular module or stage. Since the PCBs must share the various modules, a pre-emptive scheduling technique is employed, in which operations on PCBs having the highest priority will generally be processed first.

In its preferred embodiment the system 10 will process multiple PCBs in parallel. For simplicity and clarity purposes, the discussion which follows will view the system 10 from the perspective of a single highest priority PCB under test. It should be noted, however, that generally other high priority PCBs are being processed concurrently, i.e. in parallel. The configuration file and appropriate process sequence files for such highest priority PCB are read by the master control unit. These files have been provided as input to the master control unit by one or more of the alternatives previously described. The master control unit will determine from these files the stage which is required to perform the first testing or repair operations to such highest priority PCB. Similarly, the required other components, e.g., the fixture assembly 47 and cover assembly 67 for repairing and/or testing such PCB will also be established by reading the fixture correlation file. The master control unit will then read the component location file to determine if such components are within the system and the present location of the required components including the PCB. If such components are not within the system 10 the user will be instructed to input such components. These other components required to test such highest priority PCB are then automatically assigned a priority rating which is dependent upon the priority of the PCB under test. Since this PCB has the highest priority, thereby ensuring that they will be promptly transported to the required module. The master control unit is designed to interrogate on a periodic basis the various sensors included within the system 10 to update the location information (as contained within the component location file) for all components within the system 10 and ensure that the required components are present and accounted for and that on a real time basis two or more components (e.g. carriers 20, fixture assemblies 47 and cover assemblies 62) never try to occupy the same space at the same time. Similarly the appropriate sensors will also be interrogated for the status of each of the modules within the system 10 which form the various paths available to transport the components, to ensure that the modules are functioning, available, and properly positioned for such transport. In this manner the optimum available path to such test and/or repair stages can be established for each component and the process of transporting such highest priority components from their present location to the required test and/or repair stages will begin. From the information contained in the configuration file, the master control unit can ascertain the movement of the conveyor means required to transport these components to the specified stages 11 or 15 and the instructions which will be required to be issued on the network 14 to the appropriate drivers within the various modules to perform the transport. Accordingly the master control unit will timely activate the appropriate drivers to perform such transport. Similarly the appropriate sensors can be activated or interrogated to ensure that the required actions have taken place. This drive and sensor information is conveyed to and from the master control unit via the network 14. Concurrently the component location file is dynamically updated as a result of such sensor information to, as previously described, continually track the location of the various components within the system. The master control unit is therefore kept current as to whether a required module has performed the required operation. After such operation has been performed, and depending upon its priority rating the PCB will eventually be transported to the required test or repair stage according in the order specified by the process sequence file. When all the required components are present at the specified test or repair stage 11 or 15, the master control unit or the lost computer to which it is connected will activate the stage to begin performing the required operations. In the preferred embodiment the actual testing of a PCB is controlled by a host computer interfaced with the master control unit via the network 14. The particular test programs which are required to test the PCB are stored within the host computer and downloaded as required. The identity of the appropriate test program is part of the process sequence file. Furthermore the host can track the test history of the PCBs being process in order to create management reports for user.

Upon the completion of the tests of a given PCB at a given stage, the host will analyze the results of the test and instruct the master control unit to consult the process sequence file for the next event or operation which is to occur. Assuming an adequately high priority the required conveyor movement will be analyzed and carried out according to the process as has been described to facilitate this next event or operation. The master control unit will thus read the process sequence file and ascertain the next test or repair stage required. If no additional test or repair operations are required, e.g. the PCB is finally accepted or rejected, the PCB will, according to its priority rating, be transported to a buffering stage 16 or the component I/O device 80 for removal from the test system 10. If additional test or repair operations are required, the appropriate stages and modules will be interrogated and selected. In addition the master control unit will determine the associated components which will be required and which have been specified within the fixture correlation file. These may or may not be the same components used for the first test. If the appropriate fixture assemblies 47, cover assemblies 62, etc. are already within the system, their current location will be known by an entry within the component location file, otherwise such components and the relevant location information must be provided via one of the above mentioned input devices. A priority rating is again given to the fixture assembly 47 cover assembly 62, etc., based upon the current priority rating of the PCB being tested. Finally, the movement of the conveyor means which will be required to transport the components to such specified test or repair stage will be determined and initiated.

This process is repeated until such time as all test and repair operations to be performed by the system 10 have been completed. In the same manner as has already been described, the completed PCBs 19 and associated components are transported to a buffering stage 16 or the component I/O device 80 for removal. If required, the system 10 will also allow the manual removal of a PCB and associated components at a test or repair stage 11 or 15. If this is done the master control unit must be informed of such removal via the miscellaneous I/O devices discussed. It should be ·noted that typically fixture assemblies 47 and cover assemblies 62 will remain at a given test or repair stage until the tests requiring such components at that stage are completed or until the master control unit determines that the particular stage or module will be required to repair or test a higher priority PCB. This may, for example, occur when the sum of the priority codes for all the PCBs 19 of the same type (i.e., a new batch) which are being entered into the system 10 exceeds the sum of the priority codes for all of the PCBs 19 of the type currently under test (i.e., the batch being tested or repaired). In this event the components presently on that stage may be temporarily bumped or replaced by those required for the higher priority batch.

Thus the system 10 according to the present invention is able to concurrently and automatically process PCBs of different types, sizes, shapes, and configurations with little or no manual intervention. It is able to do so in an accurate, timely, and cost effective manner, with maximized throughput, thereby substantially eliminating the aforementioned limitations associated with the prior art. It must be understood that the description of the present invention as set forth above does not attempt to recite all the advantages associated therewith nor does it attempt to recite in detail all the structure employed. Furthermore, for the sake of clarity and understanding, certain operations and the detailed structure of various components, which are considered to be within the scope of one skilled in the art in light of the teachings set forth herein, have not been discussed. Having thus described several embodiments of the present invention, it must also be understood that changes may be made in the configuration, size, makeup, shape, or order of some of the parts, circuits, or methods described herein without departing from the present invention as recited in the appended claims.

## Claims

1. An automated multi-station system (10) capable of testing and/or repairing PCBs (19) of different types, concurrently, including : an input station (80) for entering PCBs (19) into said system (10) ; a plurality of test and/or repair stations (11, 15) ; a transport system interconnectting all of said stations (11, 15, 80) for transporting PCBs (19) between said stations (11, 15, 80) and control means for supervising transport of said PCBs (19) by said transport system, operation of said input station (80) and activation of said test and/or repair stations (11, 15), characterized in that :

the input station (80), the plurality of test and/or repair stations (11, 15) and the interconnecting transport system are arranged so as to allow transport by said transport system of each PCB (19) entered into said system (10) directly between any of said stations in any order ;

said control means is provided with access to a process sequence file for each type of PCB (19) concurrently processed by the system (10), the process sequence file for each type of PCB defining the test and/or repair operations required and the order of performance of said operations for that type of PCB ; and

said control means is provided with an identification of the PCB type of each PCB (19) entered into the system (10) and routes each such PCB (19) to selected stations in accordance with the process sequence file for the identified PCB type and the results of prior operations on said PCB.

2. The automated system (10) of claim 1 wherein said transport system is adapted to transport components and wherein said components include :

universal carriers (20) for mounting individual PCBs (19), said carriers (20) being adaptable to accommodate a range of sizes and configurations of PCBs (19) ;

fixture assemblies (47) ; and

vacuum cover assemblies (62), and wherein all of said components have in common an exterior configuration which facilitates transportation by said transport system.

3. The automated system (10) of claim 1 further characterized in that multiple PCBs (19) are processed in parallel by the automated system (10), a base priority code is assigned to each PCB, and said control means implements a dynamic priority rating system and pre-emptive scheduling technique in controlling the processing of the multiple PCBs (19).

4. The automated system (10) of claim 3 wherein said multiple PCBs (19) comprise a mix of PCBs of different types and said control means tracks the location of the PCBs and monitors the status of the stations and transport system.

5. The automated system (10) of claim 1 wherein said control means further comprises :

    interactive graphic means to assist in developing and to visually display a desired configuration of the automated system (10) ; and

    means connected to said interactive graphic means for automatically generating therefrom a system configuration file identifying system interconnections and containing control programs for the desired configuration.

6. The automated system (10) of claim 1 wherein said transport system comprises an arrangement of interconnected modular conveyor units (12, 13), each of said units being capable of selectively imparting movement in opposite directions to a PCB (19) located thereon.

7. The automated system (10) of claim 6 wherein at least one of said conveyor units (13) is capable of rotating a PCB (19) located thereon.

8. The automated system (10) of claim 6 further comprising a universal carrier (20) for supporting each PCB entered into the system (10), said carrier (20) comprising :

    a frame (22), and means (23, 26) for supporting a PCB (19) in said frame (22), which means is adapted to accommodate a range of sizes and configurations of PCBs (19) without requiring an adjustment of said frame (22), said frame (22) having two opposed generally parallel side members (22a, 22c), each of said side members (22a, 22c) being provided with a longitudinally extending laterally protruding ridge (29) for riding within opposed channels (92) of the conveyor units (12), and at least one of said side members having a surface (21) disposed substantially perpendicular to the direction of lateral protrusion of its ridge (29) and adapted to be engaged by drive means (32) of said conveyor units (12).

9. The automated system (10) of claim 6 wherein each modular conveyor unit (12, 13) is used to transport a component (20, 47, 62) having protruding side ridges (29, 58, 63) and each conveyor unit (12, 13) comprises :

    a generally horizontal chassis (31) supporting a pair of parallel substantially vertical spaced apart guide rails (91), the guide rails (91) defining opposed longitudinally extending channels (92) adapted to receive the projecting side ridges (29, 58, 63) of the component (20, 47, 62) ; and

    reversible drive means (32) supported by said chassis (31) for engaging a surface of said component and imparting motion to said component in a longitudinal direction.

10. The automated system (10) of claim 9 wherein one of said conveyor units (13) further comprises :

    means (95) for controllably rotating the chassis (31) about a generally vertical axis to a new orientation.

11. The automated system (10) of claim 10 wherein said surface comprises a generally vertical side surface of the component ;

    the drive means comprises a pair of driven rollers (32), one near each end of one of said guide rails (91) ; and further comprising :

    stop means supported by the chassis of each of said conveyor units and operational to selectively prevent further motion of a component in said unit ;

    first sensor means for sensing the presence of a component in each of said units ;

    second sensor means for sensing the orientation of the rotated chassis (31) of said one of said conveyor units ; and

    a controller for controlling the drive means, first and second sensor means, and rotating means of said one of said conveyor units, and drive means and first sensor means of adjacent conveyor units.

12. The automated system (10) of claim 1 further comprising :

    automated buffering stage means (16) associated with each of said test and/or repair stations (11, 15), each buffering stage means (16) being capable of temporarily storing multiple PCBs (19) and interfacing with said transport system.

13. The automated system (10) of claim 12 wherein said automated buffering stage means (16) is used for storing components and comprises :

    receptacle means (70) having a plurality of generally horizontally disposed cells, each cell being adapted to receive and support a component therein ;

    frame means (72) supporting said receptacle means (70) for bidirectional movement relative to said frame means (72) along a generally vertical axis ;

    first drive means (73) for controllably moving said receptacle means relative to said frame means ;

    second drive means (76) for selectively engaging a component in any of said cells and controllably expelling said component from the cell ; and

    sensor means for sensing the presence of components within said cells and the relative position of the receptacle means with respect to said frame means.

14. The automated system (10) of claim 13 wherein each component has protruding side ridges and each cell of the buffering stage means (16) is configured with side channels adapted to receive said ridges ; and

    said second drive means comprises at least one drive roller (76) positioned to selectively engage a generally vertical side surface of a component.

15. The automated system (10) of claim 2 wherein at least one of said stations comprises a test station, said test station comprising :

a test stage (11a), automation interface means (38) for automatically loading and unloading universal carriers (20) and fixture assemblies (47) on said test stage, and automated buffering stage means (16) for temporarily storing multiple carriers and fixture assemblies and interfacing with said transport system ; and

wherein said control means includes a test station controller providing coordinated control over the operation of the buffering stage means (16) and automation interface means (38), and activation of the test stage (11a).

16. The automated system (10) of claim 15 wherein the automation interface apparatus (38) for use on a PCB test stage comprises :

first automatic means (39, 40) for receiving and precisely depositing a test fixture assembly (47) on a test stage (11a) ;

second automatic means (39, 40) for receiving and precisely positioning a PCB (19) to be tested on said test fixture assembly (47) ;

third automatic means (85) for receiving vacuum cover means (62), supporting said vacuum cover means (62) in a non-interfering elevated position and, on command, superimposing said vacuum cover means (62) over said PCB (19) to facilitate vacuum drawing of said PCB (19) into electrical connection with said stage (11a) through said fixture assembly (47) ; and

fourth automatic means (39) for expelling said PCB (19), fixture assembly (47) and cover means (62) from said apparatus 38.

17. The automated system (10) of claim 1 wherein said control means comprises a master control means and a network of distributed individual station control means and transport system control means.

18. A method for automating test and/or repair operations to be performed on PCBs (19) in a multi-station system (10) so that such operations can be performed by the system on PCBs of different types concurrently, wherein PCBs (19) are transported between stations of the system (10) by an interconnecting transport system under the control of a control unit, characterized by the steps of :

arranging the stations and transport system so that PCBs (19) may be transported directly between different stations in any order ;

providing the control unit with access to a process sequence file for each particular type of PCB to be concurrently processed by the multi-station system (10), each process sequence file identifying test and/or repair operations and the order in which said operations are to be performed for the particular type of PCB depending upon the results of the previous operations ;

providing an indication to the control unit of the PCB type of each PCB (19) loaded into the multi-station system (10) ; and

transporting each PCB (19) loaded into the multi-station system (10) to stations within the system with said transport system in accordance with the process sequence file for the PCB type of said PCB.

19. The method of claim 18 further characterized by the step of transporting fixture assemblies (47) and vacuum cover assemblies (62) to stations of said multi-station system (10), with said transport system, under the control of said control unit, when such assemblies are needed in the performance of test and/or repair operations on the PCBs.

20. The method of claim 19 wherein multiple PCBs (19) are processed by the stations of the system (10) in parallel and further comprising the step of:

processing PCBs by the system (10) in accordance with a dynamic priority rating system and a preemptive scheduling technique.

21. The method of claim 18 wherein the step of arranging the stations and transport system comprises designing a desired configuration of the multi-station system on an interactive graphics display and automatically generating therefrom a corresponding system configuration file which identifies system interconnections and contains control programs for the desired configuration.

**Ansprüche**

1. Ein automatisches Mehrstationssystem (10), mit dem gedruckte Schaltungen PCBs (19) verschiedener Typen gleichzeitig getestet und/oder repariert werden können, das eine Eingangsstation (80) zum Eingeben von PCBs (19) in das System (10) ; eine Vielzahl von Test- und/oder Reparaturstationen (11, 15) ; ein Transportsystem, das all diese Stationen (11, 15, 80) untereinander verbindet, zum Transportieren von PCBs (19) zwischen diesen Stationen (11, 15, 80) und Steuer- und Regeleinrichtungen zum Überwachen des Transports dieser PCBs (19) durch das Transportsystem, des Betriebs der Eingangsstation (80) und der Aktivierung der Test- und/oder Reparaturstationen (11, 15) enthält, dadurch gekennzeichnet, daß :

die Eingangsstation (80), die Vielzahl der Test- und/oder Reparaturstationen (11, 15) und das verbindende Transportsystem so angeordnet sind, daß durch das Transportsystem Transport jeder PCB (19), die in das System (10) eingegeben wird, direkt zwischen beliebigen dieser Stationen in beliebiger Reihenfolge möglich ist ;

die Steuer- und Regeleinrichtung mit Zugang zu einer Bearbeitungsablaufkartei für jeden Typ PCB (19), der gleichzeitig durch das System (10) verarbeitet wird, versehen ist, wobei die Bearbeitungsablaufkartei für jeden Typ von PCB die erforderlichen Test- und/oder Reparaturbetriebsschritte und die Reihenfolge der Durchführung dieser Betriebsschritte für diesen Typ von PCB definiert ; und

die Steuer- und Regeleinrichtung mit einer Identifikation des PCB-Typs jeder PCB (19), die in das System (10) eingegeben wird, versehen ist und jede derartige PCB (19) zu ausgewählten Stationen in Übereinstimmung mit der Bearbeitungsablaufkartei für den identifizierten PCB-Typ und den Ergebnissen vorhergehender Betriebsschritte an dieser PCB leitet.

2. Das automatische System (10) nach Anspruch 1, bei dem das Transportsystem für den Transport von Baugruppen angepaßt ist und wobei diese Baugruppen :

Universalträger (20) zum Befestigen einzelner PCBs (19), wobei diese Träger (20) anpaßbar sind, um einen Bereich von Größen und Konfigurationen von PCBs (19) aufzunehmen ; Befestigungsmontagegruppen (47) und Vakuumabdeckmontagegruppen (62) umfassen und wobei alle diese Baugruppen gemeinsam eine äußere Konfiguration aufweisen, die das Transportieren durch das Transportsystem ermöglicht.

3. Das automatische System (10) von Anspruch 1, das weiterhin dadurch gekennzeichnet ist, daß mehrere PCBs (19) parallel durch das automatische System (10) verarbeitet werden, ein Basis-Prioritätscode jeder PCB zugeordnet ist und die Steuer- und Regeleinrichtung ein dynamisches Prioritätsbewertungssystem und Vorrechtsablaufverfahren beim Steuern der Verarbeitung der Mehrzahl an PCBs (19) durchführt.

4. Das automatische System (10) von Anspruch 3, bei dem die Vielzahl von PCBs (19) ein Gemisch von PCBs verschiedener Typen umfaßt und die Steuer- und Regeleinrichtung die Lage der PCBs verfolgt und den Status der Stationen und des Transportsystems überwacht.

5. Das automatische System (10) von Anspruch 1, bei dem die Steuer- und Regeleinrichtung weiterhin :

wechselwirkende graphische Einrichtungen, die am Entwickeln und visuellen Anzeigen einer gewünschten Konfiguration des automatischen Systems (10) teilnehmen, und Einrichtungen umfaßt, die mit den wechselwirkenden graphischen Einrichtungen verbunden sind, um hieraus automatisch eine Systemkonfigurationskartei zu erzeugen, die System-Zwischenverbindungen identifiziert und Steuerprogramme für die gewünschte Konfiguration enthält.

6. Das automatische System (10) von Anspruch 1, bei dem das Transportsystem eine Anordnung von untereinander verbundenen modularen Fördereinheiten (12, 13) umfaßt, wobei jede dieser Einheiten in der Lage ist, selektiv Bewegung in entgegengesetzten Richtungen einer darauf angeordneten PCB (19) zu erteilen.

7. Das automatische System (10) von Anspruch 6, bei dem wenigstens eine der Fördereinheiten (13) in der Lage ist, eine auf ihr angeordnete PCB (19) zu drehen.

8. Das automatische System (10) von Anspruch 6, das weiterhin einen Universalträger (20) für das Tragen jeder PCB, die in das System (10) eintritt, umfaßt, wobei der Träger (20) :

einen Rahmen (22) und eine Einrichtung (23, 26) zum Haltern einer PCB (19) in diesem Rahmen (22) umfaßt, wobei diese Einrichtung so ausgelegt ist, daß ein Bereich von Größen und Konfigurationen von PCBs (19) aufgenommen wird, ohne daß eine Einstellung des Rahmens (22) erforderlich ist, wobei dieser Rahmen (22) zwei gegenüberliegende allgemein parallele Seitenglieder (22a, 22c) aufweist, jedes dieser Seitenglieder (22a, 22c) mit einem sich in Längsrichtung erstreckenden seitlich vorstehenden Wulst (29) versehen ist zum Eingreifen in gegenüberliegende Kanäle (92) der Fördereinheiten (12), und wenigstens eines der Seitenglieder eine Oberfläche (21) aufweist, die im wesentlichen rechtwinklig zu der Richtung des seitlichen Vorsprungs ihres Wulstes (29) angeordnet ist und so angepaßt ist, daß es mit Antriebseinrichtungen (32) der Fördereinheiten (12) zum Eingriff kommt.

9. Das automatische System (10) von Anspruch 6, bei dem jede modulare Fördereinheit (12, 13) verwendet wird, um eine Baugruppe (20, 47, 62) mit vorspringenden Seitenwülsten (29, 58, 63) zu transportieren und jede Fördereinheit (12, 13) :

ein allgemein horizontales Chassis (31), das ein Paar paralleler im wesentlichen vertikal voneinander beabstandeter Führungsschienen (91) trägt, wobei die Führungsschienen (91) gegenüberliegende sich in Längsrichtung erstreckende Kanäle (92) definieren, die so angepaßt sind, daß sie die vorstehenden Seitenwülste (29, 58, 63) der Baugruppe (20, 47, 62) aufnehmen, und reversible Antriebseinrichtungen (32), die von dem Chassis (31) getragen werden, zum Eingreifen in eine Oberfläche der Baugruppe und um dieser Baugruppe Bewegung in einer Längsrichtung zu verleihen, umfaßt.

10. Das automatische System (10) von Anspruch 9, bei dem eine der Fördereinheiten (13) weiterhin :

eine Einrichtung (95) zum steuerbaren Drehen des Chassis (31) um eine allgemein vertikale Achse zu einer neuen Orientierung umfaßt.

11. Das automatische System (10) von Anspruch 10, bei dem die besagte Oberfläche eine allgemein vertikaSeitenoberfläche der Baugruppe umfaßt ;

die Antriebseinrichtung ein Paar angetriebener Walzen (32), eine nahe jedes Endes von einer der Führungsschienen (91), umfaßt; und das weiterhin:

eine Stopp-Einrichtung, die von dem Chassis von jeder der Fördereinheiten getragen wird und wirkt, um selektiv weitere Bewegung einer Baugruppe in dieser Einheit zu verhindern;

eine erste Sensoreinrichtung zum Erfassen des Vorhandenseins einer Baugruppe in jeder dieser Einheiten;

eine zweite Sensoreinrichtung zum Erfassen der Orientierung des gedrehten Chassis (31) von dieser einen dieser Fördereinheiten und

eine Steuereinrichtung zum Steuern der Antriebseinrichtung, der ersten und zweiten Sensoreinrichtungen und Dreheinrichtung dieser einen der Fördereinheiten und Antriebseinrichtung und

erster Sensoreinrichtung von benachbarten Fördereinheiten, umfaßt.

12. Das automatische System (10) von Anspruch 1, das weiterhin:

automatische Pufferstufeneinrichtungen (16) umfaßt, die jeder der Test- und/oder Reparaturstationen (11, 15) zugeordnet sind, wobei jede Pufferstufeneinrichtung (16) in der Lage ist, zeitweilig mehrere PCBs (19) zu speichern, und mit dem Transportsystem in Wechselwirkung zu treten.

13. Das automatische System (10) von Anspruch 12, bei dem die automatische Pufferstufeneinrichtung (16) zum Speichern von Baugruppen verwendet wird und folgendes umfaßt:

Aufnahmeeinrichtungen (70) mit einer Vielzahl von allgemein horizontal angeordneten Zellen, wobei jede Zelle so angepaßt ist, daß sie in sich eine Baugruppe aufnimmt und haltert;

Rahmeneinrichtungen (72), die die Aufnahmeeinrichtung (70) für zweifach gerichtete Bewegung relativ zu der Rahmeneinrichtung (72) entlang einer allgemein vertikalen Achse trägt;

erste Antriebseinrichtungen (73) zum steuerbaren Bewegen der Aufnahmeeinrichtung relativ zu der Rahmeneinrichtung;

zweite Antriebseinrichtungen (76) für den selektiven Eingriff mit einer Baugruppe in einer beliebigen dieser Zellen und steuerbares Herausziehen dieser Baugruppe aus der Zelle und Sensoreinrichtungen zum Erfassen des Vorhandenseins von Baugruppen innerhalb dieser Zellen und der relativen Position der Aufnameeinrichtung in Bezug auf die Rahmeneinrichtung.

14. Das automatische System (10) von Anspruch 13, bei dem jede Baugruppe vorstehende Seitenwülste aufweist und jede Zelle der Pufferstufeneinrichtung (16) mit seitlichen Kanälen versehen ist, die so angepaßt sind, daß sie diese Wülste aufnehmen, und wobei diese zweite Antriebseinrichtung wenigstens eine Antriebswalze (76) umfaßt, die so positioniert ist, daß sie selektiv mit einer allgemein vertikalen Seitenoberfläche einer Baugruppe zum Eingriff kommt.

15. Das automatische System (10) von Anspruch 2, bei dem wenigstens eine dieser Stationen eine Teststation umfaßt, wobei diese Teststation:

eine Teststufe (11a), eine Automatisierungs-Interface-Einrichtung (38) zum automatischen Beladen und Entladen von Universalträgern (20) und Befestigungsmontagegruppen (47) auf der Teststufe und automatische Pufferstufeneinrichtungen (16) zum zeitweiligen Speichern mehrerer Träger und Befestigungsmontagegruppen und Wechselwirken mit dem Transportsystem umfaßt, und

wobei die Steuereinrichtung eine Teststation-Steuereinrichtung umfaßt, die koordinierte Steuerung über den Betrieb der Pufferstufeneinrichtung (16) und der Automatisierungs-Interface-Einrichtung (38) und Aktivierung der Teststufe (11a) liefert.

16. Das automatische System (10) von Anspruch 15, bei dem die Automatisierungs-Interface-Einrichtung (38) für die Verwendung auf einer PCB-Testbühne folgendes umfaßt:

eine erste automatische Einrichtung (39, 40) zum Empfangen und präzisen Niederlegen einer Test-Befestigungsmontagegruppe (47) auf einer Testbühne (11a);

eine zweite automatische Einrichtung (39, 40) zum Empfangen und präzisen Positionieren einer zu testenden PCB (19) auf dieser Test-Befestigungsmontagegruppe (47);

eine dritte automatische Einrichtung (85) zum Empfangen einer Vakuumabdeckeinrichtung (62), die diese Vakuumabdeckeinrichtung (62) in einer nichtbeeinträchtigenden erhöhten Position trägt und auf Befehl diese Vakuumabdeckeinrichtung (62) über die PCB (19) legt, um Zug durch Vakuum auf diese PCB (19) in elektrische Verbindung mit der Testbühne (11a) durch die Befestigungsmontagegruppe (47) zu ermöglichen; und

eine vierte automatische Einrichtung (39) zum Herausziehen dieser PCB (19), der Befestigungsmontagegruppe (47) und der Abdeckeinrichtung (62) aus der Einrichtung (38).

17. Das automatische System (10) von Anspruch 1, bei dem die Steuer- und Regeleinrichtung eine MasterSteuereinrichtung und ein Netzwerk verteilter einzelner Stationssteuereinrichtungen und Transportsystem-Steuereinrichtungen umfaßt.

18. Ein Verfahren zum Automatisieren von Test- und/oder Reparaturbetriebsschritten, die an PCBs (19) in einem Mehrstationssystem (10) durchgeführt werden sollen, so daß derartige Betriebsschritte durch das System an PCBs verschiedener Typen gleichzeitig durchgeführt werden können, bei dem PCBs (19) zwischen Stationen des Systems (10) durch ein Zwischenverbindungen schaffendes Transportsystem unter der Steuerung einer Steuereinheit transportiert werden, gekennzeichnet durch die Verfahrensschritte :

Anordnen der Stationen und des Transportsystems so, daß PCBs (19) direkt zwischen verschiedenen Stationen in beliebiger Reihenfolge transportiert werden können ;

Versehen der Steuer- und Regeleinheit mit Zugang zu einer Verfahrensablaufkartei für jeden besonderen Typ der PCB, die gleichzeitig durch das Mehrstationssystem (10) verarbeitet werden soll, wobei jede Verfahrensablaufkartei Test- und/oder Reparaturbetriebsschritte und die Reihenfolge, in der diese Betriebsschritte durchgeführt werden sollen, für den besonderen Typ PCB in Abhängigkeit von den Ergebnissen der vorhergehenden Betriebsschritte identifiziert ;

Liefern einer Anzeige an die Steuereinheit des PCB-Typs jeder PCB (19), die in das Mehrstationssystem (10) eingebracht worden ist ; und

Transportieren jeder PCB (19), die in das Mehrstationssystem (10) eingebracht worden ist, zu Stationen innerhalb des Systems mit dem Transportsystem in Übereinstimmung mit der Verfahrensablaufkartei für den PCB-Typ dieser PCB.

19. Verfahren nach Anspruch 18, das weiterhin durch den Verfahrensschritt gekennzeichnet ist, daß Befestigungsmontagegruppen (47) und Vakuumabdeckbaugruppen (62) zu Stationen des Mehrstationssystems (10) mit dem Transportsystem unter der Steuerung der Steuer- und Regeleinheit transportiert werden, wenn solche Baugruppen bei der Durchführung von Test- und/oder Reparaturbetriebsschritten an den PCBs benötigt werden.

20. Das Verfahren von Anspruch 19, bei dem mehrere PCBs (19) durch die Stationen des Systems (10) parallel bearbeitet werden und das weiterhin den Verfahrensschritt umfaßt :

daß PCBs durch das System (10) in Übereinstimmung mit einem dynamischen Prioritätsbewertungssystem und einem Vorrechtsablaufverfahren bearbeitet werden.

21. Das Verfahren von Anspruch 18, bei dem der Verfahrensschritt des Anordnens der Stationen und des Transportsystems das Auslegen einer gewünschten Konfiguration des Mehrstationssystems auf einer graphischen Wechselwirkungsanzeige und das automatische Erzeugen einer entsprechenden Systemkonfigurationskartei daraus, die die System-Zwischenverbindungen identifiziert und Steuerprogramme für die gewünschte Konfiguration enthält, umfaßt.

**Revendications**

1. Système multiposte automatisé (10) capable de tester et/ou de réparer des cartes à circuits imprimés (19) de différents types, comprenant simultanément : un poste d'entrée (80) destiné à l'introduction de cartes à circuits imprimés (19) dans le système (10) ; une pluralité de postes d'essai et/ou de réparation (11, 15), un système de transport reliant entre eux tous les postes (11, 15, 80) pour l'acheminement des cartes à circuits imprimés (19) entre les postes (11, 15, 80) et des moyens de commande pour le contrôle du transport des cartes à circuits imprimés (19) par le système de transport, le fonctionnement du poste d'entrée (80) et l'actionnement des postes d'essai et/ou de réparation (11, 15), caractérisé en ce que :

le poste d'entrée (80), la pluralité des postes d'essai et/ou de réparation (11, 15) et le système de transport d'interliaison sont disposés de façon à permettre l'acheminement par le système de transport de chaque carte à circuits imprimés (19) introduite dans le système (10) directement entre l'un quelconque des postes et dans un ordre quelconque ;

les moyens de commande comportent un accès à un dossier de séquence de traitement pour chaque type de carte à circuits imprimés (19) traitée simultanément par le système (10), le dossier de séquence de traitement pour chaque type de carte à circuits imprimés définissant les opérations d'essai et/ou de réparation nécessaires et l'ordre d'exécution de ces opérations pour ce type de carte à circuits imprimés ; et

les moyens de commande comportent une identification du type de carte à circuits imprimés pour chaque carte à circuits imprimés (19) introduite dans le système (10) et achemine chacune de ces cartes à circuits imprimés (19) vers les postes sélectionnés en fonction du dossier de séquence de traitement pour le type de carte à circuits imprimés identifié et les résultats des opérations antérieures sur la carte à circuits imprimés.

2. Système automatisé (10) selon la revendication 1, dans lequel le système de transport est apte à acheminer des composants et dans lequel ces composants comprennent :

des supports universels (20) destinés au montage des différentes cartes à circuits imprimés (19), ces supports (20) pouvant recevoir une gamme de tailles et de configurations de cartes à circuits imprimés (19) ;

des dispositifs de montage (47) ; et des ensembles de couvercle sous vide (62) et dans lequel la totalité des composants ont en commun une configuration extérieure qui facilite l'acheminement par le système de transport.

3. Système automatisé (10) selon la revendication 1 caractérisé de plus en ce que des cartes à circuits imprimés multiples (19) sont traitées en parallèle par le système automatisé (10), un code de priorité de base étant affecté à chaque carte à circuits imprimés et les moyens de commande mettent en oeuvre un système d'évaluation de priorité dynamique et une technique d'ordonnancement préventive pour la commande du traitement des cartes à circuits imprimés multiples (19).

4. Système automatisé (10) selon la revendication 3, dans lequel les cartes à circuits imprimés comprennent un mélange de cartes à circuits imprimés de différents types et les moyens de commande détectent l'emplacement des cartes à circuits imprimés et surveillent l'état des postes et du système de transport.

5. Système automatisé (10) selon la revendication 1, dans lequel les moyens de commande comprennent de plus : des moyens graphiques interactifs pour faciliter le développement et l'affichage visuel d'une condes moyens reliés au moyen graphique interactif destinés à produire automatiquement un dossier de configuration système identifiant les interliaisons de système et contenant des programmes de commande pour la configuration souhaitée.

6. Système automatisé (10) selon la revendication 1 dans lequel le système de transport comprend un agencement d'unités de convoyeur modulaire reliées entre elles (12, 13), chacune de ces unités étant capable d'imprimer sélectivement un mouvement dans les directions opposées à une carte à circuits imprimés (19) située sur celle-ci.

7. Système automatisé (10) selon la revendication 6, dans lequel au moins l'une des unités de convoyeur (13) est apte à mettre en rotation une carte à circuits imprimés (19) située sur celle-ci.

8. Système automatisé (10) selon la revendication 6 comprenant de plus un support universel (20) destiné à recevoir chaque carte à circuits imprimés introduite dans le système (10), ce support (20) comprenant :

un châssis (22), et des moyens (23, 26) destinés à supporter une carte à circuits imprimés (19) dans le châssis (22), lesquels moyens sont aptes à recevoir une gamme de tailles et de configurations de cartes à circuits imprimés (19) sans nécessiter un réglage du châssis (22), le châssis (22) comportant deux éléments latéraux en regard de façon générale parallèles entre eux (22a, 22c), chacun des éléments latéraux (22a, 22C) étant muni d'une nervure s'étendant longitudinalement et faisant saillie latéralement (29) pour le déplacement à l'intérieur de canaux en regard (92) des unités de convoyeur (12), et au moins l'un des éléments latéraux comportant une surface (21) disposée sensiblement de façon perpendiculaire à la direction de la saillie latérale de sa nervure (29) et apte à coopérer avec des moyens d'entraînement (32) des unités de convoyeur (12).

9. Système automatisé (10) selon la revendication 6 dans lequel chaque unité de convoyeur modulaire (12, 13) est utilisée pour transporter un composant (20, 47, 62) ayant des nervures latérales en saillie (19, 58, 63) et chaque unité de convoyeur (12, 13) comprend :

un châssis de façon générale horizontal (31) supportant une paire de rails de guidage sensiblement parallèles, verticaux, espacés entre eux (91), les rails de guidage (91) définissant des canaux en regard s'étendant longitudinalement (92) aptes à recevoir les nervures latérales en saillie (29, 58, 63) du composant (20, 47, 62) ; et, des moyens d'entraînement réversible (32) supportés par le châssis (31) pour l'engagement avec une surface du composant et transmettre le mouvement au composant dans une direction longitudinale.

10. Système automatisé (10) selon la revendication 9, dans lequel l'une des unités de convoyeur (13) comprend de plus :

des moyens (95) destinés à la mise en rotation de façon contrôlable du châssis (31) autour d'un axe généralement vertical dans une nouvelle orientation.

11. Système automatisé (10) selon la revendication 10 dans lequel la surface comprend une surface latérale généralement verticale du composant ;

des moyens d'entraînement comprennent une paire de rouleaux commandés (32), une à proximité de chaque extrémité des rails de guidage (91) ; et comprenant de plus :

une butée supportée par le châssis de chaque unité de convoyeur et opérante pour empêcher sélectivement la poursuite du mouvement d'un composant dans l'unité.

Des premiers capteurs destinés à détecter la présence d'un composant dans chaque unité ;

des seconds capteurs destinés à détecter l'orientation du châssis mis en rotation (31) de l'une des unités de convoyeur ; et

un organe de commande destiné à commander les moyens d'entraînement, des premiers et seconds capteurs et des moyens de mise en rotation de l'une des unités de convoyeur, et des moyens d'entraînement et des premiers capteurs des unités de convoyeur contiguës.

12. Le système automatisé (12) selon la revendication 1 comprenant de plus :

des moyens de zone tampon automatisés (16) associés à chacun des postes d'essai et/ou de réparation (11, 15), chaque zone de tampon (16) pouvant stocker des cartes à circuits imprimés multiples (19) et à servir d'interface avec les systèmes de transport.

13. Système automatisé (10) selon la revendication 12, dans lequel la zone tampon automatisée (16) est utilisée pour stocker des composants et comprend :

des réceptacles (70) comportant une pluralité de cellules disposées de façon générale horizontalement, chaque cellule étant apte à recevoir et à supporter un composant ;

des châssis (72) supportant les réceptacles (70) pour le mouvement bidirectionnel par rapport au châssis (72) le long d'un axe généralement vertical ;

des premiers moyens d'entraînement (73) destinés à déplacer de façon contrôlée les réceptacles
par rapport aux châssis ;

les seconds moyens d'entraînement (76) pour
engager de façon sélective un composant dans
l'une quelconque des cellules et à expulser de
façon contrôlable le composant de la cellule ; et

des capteurs destinés à détecter la présence de
composants à l'intérieur des cellules et la position
relative du réceptacle par rapport au châssis ;

14. Système automatisé (10) selon la revendication 13 dans lequel chaque composant comporte des
nervures latérales en saillie et chaque cellule de la
zone tampon (16) présente une configuration avec
des canaux latéraux aptes à recevoir ces nervures ;
et

des seconds moyens d'entraînement comprennent au moins un rouleau de commande (76) positionné de façon à coopérer sélectivement avec une
surface latérale généralement verticale d'un composant.

15. Système automatisé (10) selon la revendication 2 dans lequel au moins l'un des postes comprend
un poste d'essai, le poste d'essai comprenant :

un poste d'essai (11a), des moyens d'interface
automatisés (38) pour charger et décharger automatiquement les porteurs universels (20) et des
ensembles de montage (47) sur la zone d'essai
et la zone tampon automatisée (16) pour stocker
temporairement une multiplicité de porteurs et
d'ensembles de montage et servir d'interface
avec le système de transport ; et

dans lequel les moyens de commande comprennent un système de commande poste d'essai
fournissant une commande coordonnée sur le
fonctionnement de la zone tampon (16) et de
l'interface d'automatisation (38) et l'actionnement
de la zone d'essai (11a).

16. Système automatisé (10) selon la revendication 15, dans lequel l'appareil d'interface d'automatisation (38) destiné à l'utilisation sur un poste d'essai
de carte à circuits imprimés comprend :

des premiers moyens automatiques (39, 40) destinés à recevoir et à déposer avec précision un
ensemble de montage d'essai (47) sur un poste
d'essai (11a) ;

des seconds moyens automatiques (39, 40) destinés à recevoir et à positionner avec précision
une carte à circuits imprimés (19) destinée à être
testée sur l'ensemble de montage d'essai (47) ;

des troisièmes moyens automatiques (85) destinés à recevoir des moyens de couvercle sous
vide (62), dans une position surélevée non interférente et, sur commande, à superposer les
moyens de couvercle sous vide (62) sur la carte
à circuits imprimés (19) pour faciliter l'attraction sous vide de la carte à circuits imprimés (19) pour
la mise en connection électrique avec le poste
(11a) par l'ensemble de montage (47) ; et

des quatrièmes moyens automatiques (39) pour
expulser la carte à circuits imprimés (19), un
ensemble de montage (47) et des moyens de
couvercle (62) de l'appareil (38).

17. Système automatisé (10) selon la revendication 1, dans lequel les moyens de commande
comprennent un dispositif de commande centrale et
un réseau de moyens de commande de postes individuels répartis et de moyens de commande du système de transport.

18. Procédé pour l'automatisation d'opérations
d'essai et/ou de réparation à effectuer sur des cartes
à circuits imprimés (19) dans un système multiposte
(10) de façon que ces opérations puissent être réalisées par le système sur des cartes à circuits imprimés
de différents types et ce simultanément, les cartes à
circuits imprimés (19) étant transportées entre les
postes du système (10) par un système de transport
d'interliaison sous la commande d'une unité de
commande, caractérisé par les étapes consistant à :

agencer les postes et systèmes de transport de
façon que les cartes à circuits imprimés (19) puissent être transportées directement entre les différents postes dans n'importe quel ordre ;

munir l'unité de commande d'un accès à un dossier de séquence de traitement pour chaque type
particulier de carte à circuits imprimés à traiter
simultanément par le système multiposte (10),
chaque dossier de séquence de traitement identifiant les opérations d'essai et/ou de réparation et
l'ordre dans lequel ces opérations doivent être
effectuées pour le type particulier de carte à circuits imprimés en fonction des résultats des opérations précédentes ;

fournir une indication à l'unité de commande du
type de carte à circuits imprimés pour chaque
carte à circuits imprimés (19) chargée dans le
système multiposte (10) ; et

transporter chaque carte à circuits imprimés (19)
chargée dans le système multiposte (10) à destination des postes dans le système-au moyen du
système de transport en fonction du dossier de
séquence de traitement pour le type de carte à
circuits imprimés concerné.

19. Procédé selon la revendication 18, caractérisé de plus par l'étape consistant à transporter les
ensembles de montage (47) et les ensembles de couvercle sous vide (62) à destination des postes du système multiposte (10), avec le système de transport,
sous la commande de l'unité de commande, lorsque
ces ensembles sont requis pour l'exécution d'opérations d'essai et/ou de réparation sur la carte à circuits
imprimés.

20. Procédé selon la revendication 19, dans
lequel une multiplicité de cartes à circuits imprimés (19) sont traitées par les postes du système (10) en parallèle et comprenant de plus l'étape consistant à :

traiter les cartes à circuits imprimés par le système (10) selon un système d'évaluation de priorité dynamique et une technique de programmation préemptive.

21. Procédé selon la revendication 18, dans lequel l'étape consistant à disposer les postes et le système de transport comprend la mise au point d'une configuration souhaitée d'un système multiposte sur un écran d'affichage graphique interactif et la production automatiquement à partir de celui-ci d'un dossier de configuration de système correspondant qui identifie les interliaisons du système et contient les programmes de commande pour la configuration souhaitée.

FIG. 1

FIG. 3

FIG. 2

FIG. 4

EP 0 247 141 B1

FIG. 6

FIG. 5

FIG. 7

FIG. 8

FIG. 9

FIG. 10

EP 0 247 141 B1

FIG. II

FIG. 12

FIG. 13

SECTION A-A

READ SYSTEM
CONFIGURATION FILE

INITIALIZE SYSTEM

IDENTIFY AND INPUT
PCBs TO BE TESTED
OR REPAIRED

ASSIGN PCBs
PRIORITY CODE

DETERMINE HIGHEST
PRIORITY PCB

READ PROCESS
SEQUENCE FILE

IDENTIFY REQUIRED
OPERATIONS AND DETERMINE
AVAILABILITY OF STAGES
AND SYSTEM MODULES

READ FIXTURE
CORRELATION FILE

INPUT REQUIRED
COMPONENTS

CORRELATE PCB PRIORITY
WITH PRIORITY OF
OTHER COMPONENTS

INPUT LOCATION OF
REQUIRED COMPONENTS
TO OR FROM COMPONENT
LOCATION FILE

DETERMINE OPTIMUM
PATH BETWEEN PRESENT
LOCATION AND REQUIRED

TRANSPORT COMPONENTS TO
REQUIRED DESTINATION

ACTIVATE DRIVERS
AND SENSORS

UPDATE LOCATIONS
AND PRIORITIES FILE
AND DETERMINE IF STILL          N
HIGHEST PRIORITY

N   COMPONENT HAS ARRIVED
AT DESTINATION

DESTINATION IS A              N
TEST OR REPAIR
STATION

ACTIVATE TEST OR
REPAIR STAGE

NOTIFY MASTER CONTROL
UNIT WHEN TEST OR
REPAIR DONE AND
INPUT RESULTS

UPDATE PRIORITIES FILE
AND DETERMINE IF              N
STILL HIGHEST PRIORITY

READ PROCESS
SEQUENCE FILE

DETERMINE WHETHER
ADDITIONAL TEST OR           N
REPAIR OPERATIONS
ARE REQUIRED

*FIG. 14*

31

FIG. 15

```
┌──────────┐   ┌──────────┐   ┌──────────┐   ┌──────────┐
│   HOST   │   │  MISC.   │   │  MASTER  │   │COMPONENT │
│ COMPUTER │   │   I/O    │   │ CONTROL  │   │INSERTION │
│          │   │ DEVICES  │   │   UNIT   │   │ STATION  │
└────┬─────┘   └────┬─────┘   └────┬─────┘   └────┬─────┘
```

| | | | |
|---|---|---|---|
| TEST STAGE | TEST STAGE | REPAIR STAGE | CONVEYOR (I) |
| AUTOMATION INTERFACE | AUTOMATION INTERFACE | AUTOMATION INTERFACE | SLAVES |
| RAIL AIR CYLINDERS | RAIL AIR CYLINDERS | RAIL AIR CYLINDERS | ROTATION DRIVER |
| RAIL LIFT DRIVER | RAIL LIFT DRIVER | RAIL LIFT DRIVER | DRIVE WHEEL DRIVER |
| CARRIAGE SOLENOIDS | CARRIAGE SOLENOIDS | CARRIAGE SOLENOIDS | DRIVE WHEEL DRIVER |
| CARRIAGE DRIVERS | CARRIAGE DRIVERS | CARRIAGE DRIVERS | SENSORS |
| SENSORS | SENSORS | SENSORS | STOP SOLENOIDS |

BUFFERING STAGE (I)

SLAVES

INDEXER DRIVER

DRIVE WHEEL DRIVER

DRIVE WHEEL DRIVER

SENSORS

STOP SOLENOIDS

EP 0 247 141 B1